# EUROPEAN PATENT APPLICATION

(11) **EP 4 310 902 A1**
(43) Date of publication of application: **24.01.2024**
(21) Application number: 23185832.5
(22) Date of filing: 17.07.2023
(51) Int. Cl.: H01L 21/8234, H01L 27/088, H01L 29/66

(54) **INTEGRATED CIRCUIT SEMICONDUCTOR DEVICE**

(30) Priority: 22.07.2022 KR 20220091319
(71) Applicant: Samsung Electronics Co., Ltd., Suwon-si, Gyeonggi-do 16677 (KR)
(72) Inventor: PARK, Taejin, 16677 Suwon-si, Gyeonggi-do (KR); KIM, Kyujin, 16677 Suwon-si, Gyeonggi-do (KR); KIM, Bongsoo, 16677 Suwon-si, Gyeonggi-do (KR); KIM, Huijung, 16677 Suwon-si, Gyeonggi-do (KR); PARK, Chulkwon, 16677 Suwon-si, Gyeonggi-do (KR); YOON, Gyunghyun, 16677 Suwon-si, Gyeonggi-do (KR); CHAE, Heejae, 16677 Suwon-si, Gyeonggi-do (KR)
(74) Representative: Kuhnen & Wacker Patent- und Rechtsanwaltsbüro PartG mbB

(57) **Abstract**

An Integrated Circuit (IC) semiconductor device includes: field insulating layers buried in field trenches disposed apart from each other inside a substrate; active regions defined by the field insulating layers; and active fins disposed on the active regions and protruding from surfaces of the field insulating layers. The field insulating layers include a first subfield insulating layer and a second subfield insulating layer, and a surface of the first subfield insulating layer is disposed at a level lower than a level of a surface of the second subfield insulating layer.

## Description

### BACKGROUND

### 1. Field

The present disclosure relates to an Integrated Circuit (IC) semiconductor device, and more particularly, to an IC semiconductor device including active fins.

### 2. Description of Related Art

As the degree of integration of IC semiconductor devices has increased, a design rule for components constituting the IC devices has decreased. In a highly-scaled IC semiconductor device, it is necessary to increase a height of active fins. An increase in the height of active fins may improve electrical characteristics of IC semiconductor devices, e.g., a short-channel effect or a current driving capability may be improved.

### SUMMARY

According to an aspect of the present disclosure, an Integrated Circuit (IC) semiconductor device includes: field insulating layers buried in field trenches disposed apart from each other inside a substrate; active regions defined by the field insulating layers; and active fins disposed on the active regions and protruding from surfaces of the field insulating layers. The field insulating layers include a first subfield insulating layer and a second subfield insulating layer, and a surface of the first subfield insulating layer is disposed at a level lower than a level of a surface of the second subfield insulating layer.

According to another aspect of the present disclosure, an IC semiconductor device includes: field insulating layers buried in field trenches disposed apart from each other inside a substrate; active regions defined by the field insulating layers; and active fins disposed on the active regions and protruding from surfaces of the field insulating layers. The field insulating layers include a first field insulating layer having a first width. A second field insulating layer having a second width that is less than the first width. The first field insulating layer includes a first subfield insulating layer and a second subfield insulating layer. A surface of the first subfield insulating layer is disposed at a level lower than a level of a surface of the second subfield insulating layer.

According to another aspect of the present disclosure, an integrated circuit (IC) semiconductor device includes: field insulating layers buried in field trenches disposed apart from each other inside a substrate; active regions defined by the field insulating layers; and active fins disposed on the active regions and protruding from surfaces of the field insulating layers. The field insulating layers include a first field insulating layer having a first width and a second field insulating layer having a second width that is less than the first width. The first field insulating layer includes a first subfield insulating layer and a second subfield insulating layer. A surface of the first subfield insulating layer and a surface of the second subfield insulating layer have concave shapes.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a layout diagram of an integrated circuit (IC) semiconductor device according to an embodiment;
FIG. 2 is a partial layout diagram used in a method of manufacturing an IC semiconductor device according to an embodiment;
FIGS. 3A to 11D are cross-sectional views illustrating a method of manufacturing an IC semiconductor device and an IC semiconductor device manufactured by the method according to an embodiment;
FIG. 12 is an enlarged cross-sectional view of an IC semiconductor device according to an embodiment;
FIGS. 13A to 18D are cross-sectional views illustrating a method of manufacturing an IC semiconductor device and an IC semiconductor device manufactured by the method according to an embodiment;
FIGS. 19A to 23D are cross-sectional views illustrating a method of manufacturing an IC semiconductor device and an IC semiconductor device manufactured by the method according to an embodiment;
FIG. 24 is a system including an IC semiconductor device according to an embodiment of the present disclosure; and
FIG. 25 is a memory card including an IC semiconductor device according to an embodiment of the present disclosure.

### DETAILED DESCRIPTION

Hereinafter, embodiments are described in detail with reference to the accompanying drawings. The following embodiments may be implemented individually, or may be combined to be implemented. Therefore, the present disclosure is not construed as being limited to one embodiment.

In this specification, a singular form of the elements may include a plural form unless the context clearly indicates otherwise. In the present specification, the drawings are exaggerated in order to more clearly describe the present disclosure.

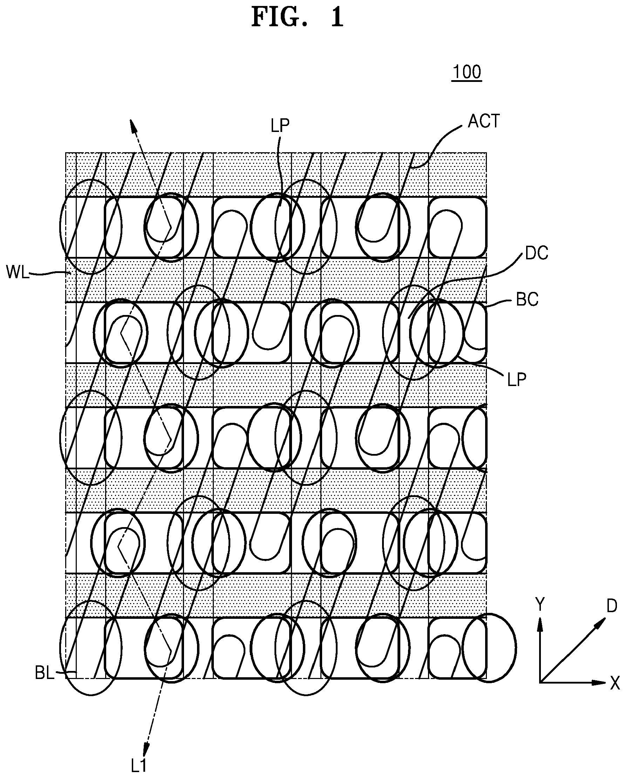

FIG. 1 is a layout diagram of an Integrated Circuit (IC) semiconductor device 100 according to an embodiment. In FIG. 1, a first direction (an X direction) may be a word line direction, a second direction (a Y direction) may be a bit line direction, and a third direction (a D direction) may be a diagonal direction. Hereinafter, a layout of the IC semiconductor device 100 is described in more detail, and the present disclosure is not limited to the layout of FIG. 1.

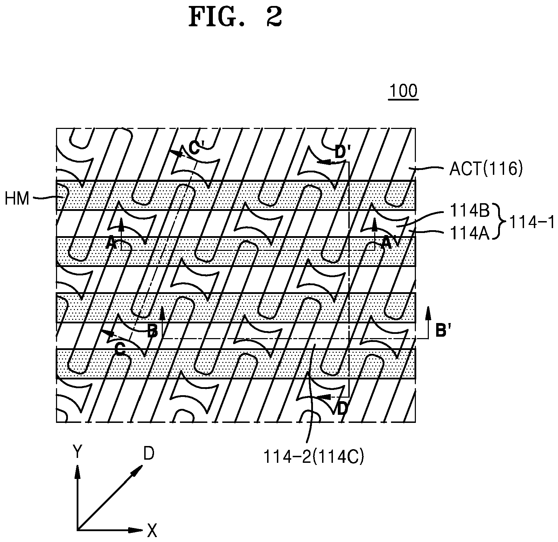

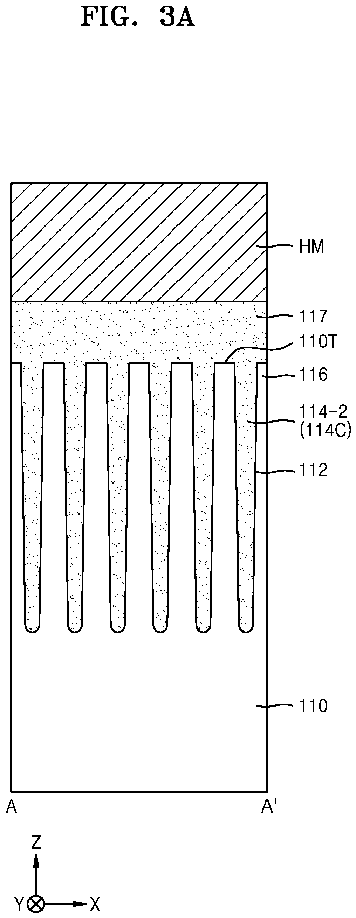

In some embodiments, the IC semiconductor device 100 may include a memory device, e.g., a Dynamic Random Access Memory (DRAM) device. The IC semiconductor device 100 may include a plurality of active regions ACT. The active regions ACT may be defined through field insulating layers (114-1 and 114-2 of FIGS. 3A to 3D) formed on a substrate 110 of FIGS. 3A to 3D. The field insulating layers may be device isolation insulating layers. As a design rule of the IC semiconductor device 100 decreases, the active regions ACT may be disposed in a bar shape of a diagonal line or an oblique line, as illustrated in FIGS. 1 and 2.

A plurality of word lines WL extending parallel to each other in the first direction (the X direction) across the active regions ACT may be located on the active regions ACT. The word lines WL may be gate lines. The word lines WL may include gate electrodes. The word lines WL may be disposed at the same interval.

A width of the word lines WL or an interval between the word lines WL may be determined based on a design rule. A plurality of bit lines BL extending to be parallel to each other in the second direction (the Y direction) orthogonal to the word line WL may be disposed on the word lines WL. The bit lines BL may also be disposed at the same interval. A width of the bit lines BL or an interval between the word lines BL may be determined according to a design rule.

According to an embodiment of the present disclosure, the IC semiconductor device 100 may include various contact arrangements formed on the active regions ACT, e.g., direct contacts DC, buried contacts BC, landing pads LP, and the like. Here, the direct contacts DC may refer to contacts connecting the active regions ACT to the bit lines BL, and the buried contacts BC may refer to contacts connecting the active regions ACT to a lower electrode of a capacitor.

In general, a contact area between the buried contacts BC and the active regions ACT may be very small in terms of an arrangement structure. Accordingly, conductive landing pads LP may be introduced to increase a contact area with the lower electrode of the capacitor, as well as increase the contact area with the active regions ACT. In the present embodiment, the landing pads LP may be disposed between the buried contacts BC and the lower electrode of the capacitor. As described above, by increasing the contact area through the introduction of the landing pads LP, contact resistance between the active regions ACT and the lower electrode of the capacitor may be reduced.

In the IC semiconductor device 100, the direct contacts DC may be disposed at central portions of the active regions ACT, and the buried contacts BC may be disposed at both ends of the active regions ACT. As the buried contacts BC are disposed at both ends of the active regions ACT, the landing pads LP may be arranged to be adjacent to both ends of the active regions ACT to partially overlap the buried contacts BC.

The word lines WL may be buried in the substrate 110 of the IC semiconductor device 100, and may be arranged to cross the active regions ACT between the direct contacts DC or the buried contacts BC. As illustrated in FIG. 1, two word lines WL are arranged to cross one active region ACT. As the active regions ACT are arranged in a diagonal shape (the direction D), the active regions ACT may have a predetermined angle less than 90 degrees with the word lines WL.

The direct contacts DC and the buried contacts BC are symmetrically arranged, and accordingly, may be arranged on a straight line along an X-axis and a Y-axis. The landing pads LP may be arranged in a zigzag shape L1 in the second direction (the Y direction) in which the bit lines BL extend, unlike the direct contacts DC and the buried contacts BC.

In addition, the landing pads LP of the same line along the Y direction may be arranged to overlap the same side portions of the respective bit lines BL in the first direction (the X direction) in which the word lines WL extend. For example, the landing pads LP of the first line may overlap the left sides of the corresponding bit lines BL, respectively, and the landing pads LP of the second line may overlap the right sides of the corresponding bit line BL, respectively.

FIG. 2 is a partial layout diagram used in a method of manufacturing an IC semiconductor device according to an embodiment. FIG. 2 may be a layout diagram that is substantially the same as that of FIG. 1. FIG. 2 does not show word lines WL, bit lines BL, and contact arrangements, such as direct contacts DC, buried contacts BC, and landing pads LP, which are illustrated in FIG. 1.

FIG. 2 further shows field insulating layers and hard mask patterns HM. The field insulating layers may include a first field insulating layer 114-1 and a second field insulating layer 114-2. The first field insulating layer 114-1 may be disposed in a region having a large distance (or width) between the active regions ACT and 116 in a plan view. The second field insulating layer 114-2 may be disposed in a region having a small distance (or width) between the active regions ACT 116, compared to the first field insulating layer 114-1 in a plan view.

The first field insulating layer 114-1 may include a first subfield insulating layer 114A and a second subfield insulating layer 114B. The second field insulating layer 114-2 may include a third subfield insulating layer 114C.

The hard mask patterns HM may be disposed to extend parallel to each other in the first direction (the X direction). The hard mask patterns HM may not overlap the word lines WL described above with reference to FIG. 1. The hard mask patterns HM may be arranged to extend to be parallel to each other in the first direction (the X direction) between the word lines WL described above with reference to FIG. 1.

FIGS. 3A to 11D are cross-sectional views illustrating a method of manufacturing an IC semiconductor device and an IC semiconductor device manufactured by the method according to an embodiment.

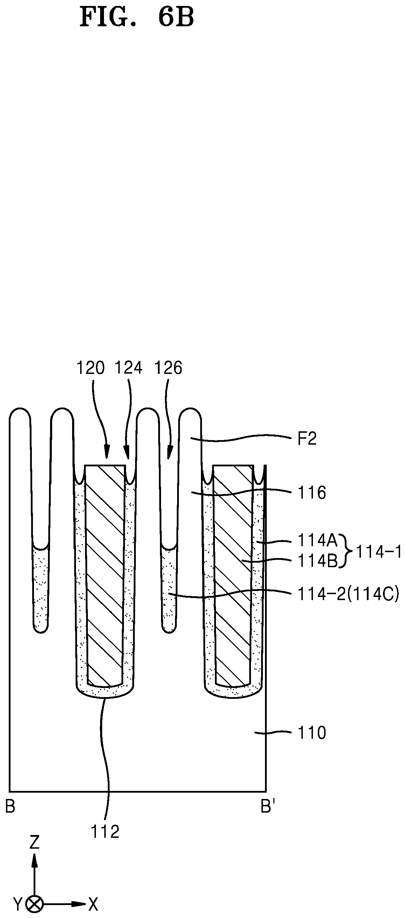

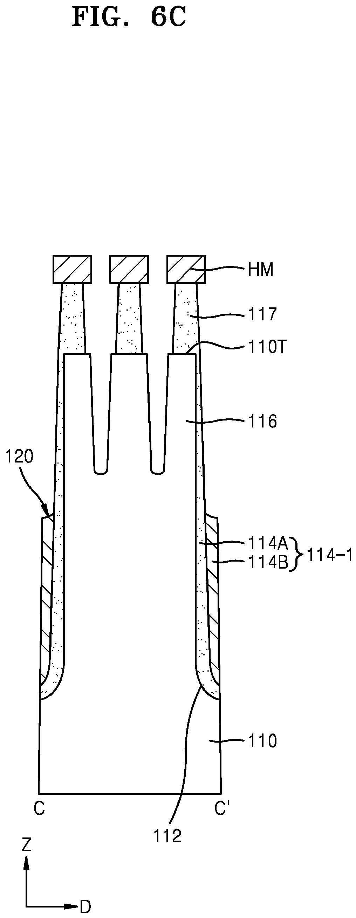

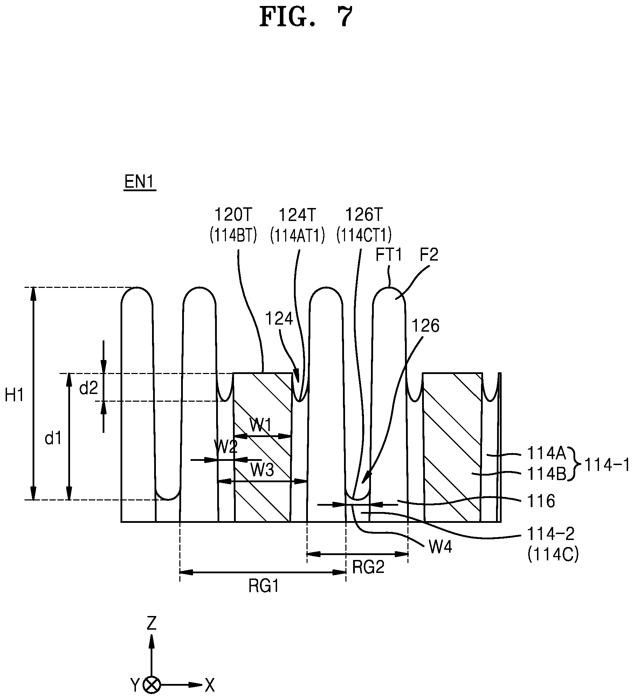

FIGS. 3A to 6A and FIGS. 8A to 11A are cross-sectional views taken along line A-A' of FIG. 2, FIGS. 3B to 6B and FIGS. 8B to 11B are cross-sectional views taken along line B-B' of FIG. 2, FIGS. 3C to 6C and FIGS. 8C to 11C are cross-sectional views taken along line C-C' of FIG. 2, and FIGS. 3D to 6D and FIGS. 8D to 11D are cross-sectional views taken along line D-D' of FIG. 2. FIG. 7 is a partially enlarged cross-sectional view of FIG. 6B. Hereinafter, a fourth direction (a Z direction) may be a direction perpendicular to the first direction (the X direction), the second direction (the Y direction), and the third direction (the D direction).

In FIGS. 3A to 3D, field trenches 112 apart from each other are formed in the substrate 110, and field insulating layers are formed in the field trenches 112. The field trenches 112 may be trenches for device isolation. The field trenches 112 are formed by etching the substrate 110 from a surface 110T (or an upper surface) of the substrate 110 to the inside. The field insulating layers may be device isolation insulating layers. The field insulating layers may be formed by filling an inside of the field trenches 112 with insulating layers.

The active regions 116 may be defined by the field insulating layers in the substrate 110. The active regions 116 may each have a relatively long island shape having a minor axis and a major axis as shown in FIG. 2. As shown in FIG. 2, the active regions 116 may be located in an oblique shape in the diagonal direction (the D direction) to have an angle less than 90 degrees with respect to the word lines WL extending in the first direction (the X direction).

The substrate 110 may include silicon (Si), e.g., crystalline Si, polycrystalline Si, or amorphous Si. In other embodiments, the substrate 110 may include Germanium (Ge) or a compound semiconductor, such as Silicon Germanium (SiGe), Silicon Carbide (SiC), Gallium Arsenide (GaAs), Indium Arsenide (InAs), or Indium Phosphide (InP). In some embodiments, the substrate 110 may include a conductive region, e.g., a well doped with an impurity, or a structure doped with an impurity.

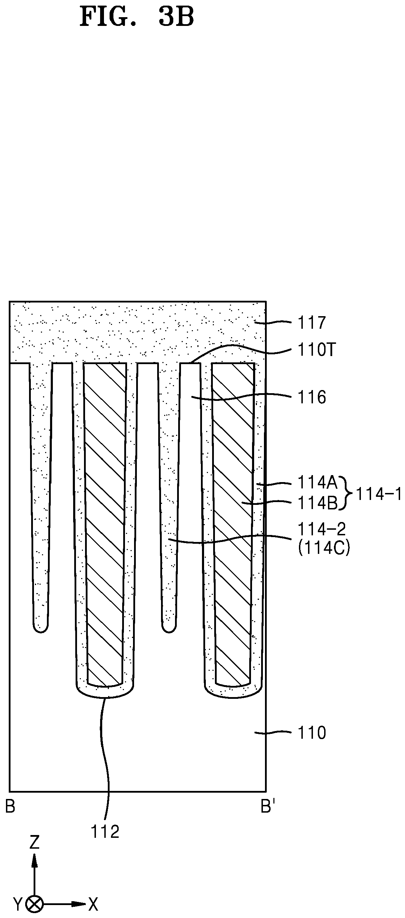

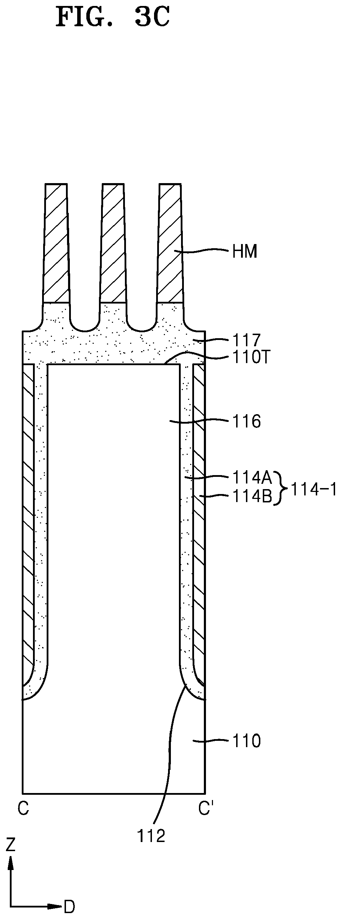

The field insulating layers may include the first field insulating layer 114-1 and the second field insulating layer 114-2. The first field insulating layer 114-1 and the second field insulating layer 114-2 may include the first field insulating layer 114-1 as shown in FIG. 3B or 3C. The first field insulating layer 114-1 may include a first subfield insulating layer 114A and a second subfield insulating layer 114B.

The first subfield insulating layer 114A and the second subfield insulating layer 114B may include different materials. In some embodiments, the first subfield insulating layer 114A may include a material having a higher etch selectivity with respect to the hard mask patterns HM than the second subfield insulating layer 114B.

For example, the first subfield insulating layer 114A may include a Silicon Oxide layer, and the second subfield insulating layer 114B may include a Silicon Nitride layer. However, a configuration of the first field insulating layer 114-1 is not limited thereto. For example, the first field insulating layer 114-1 may include a multilayer including a combination of at least three types of insulating layers.

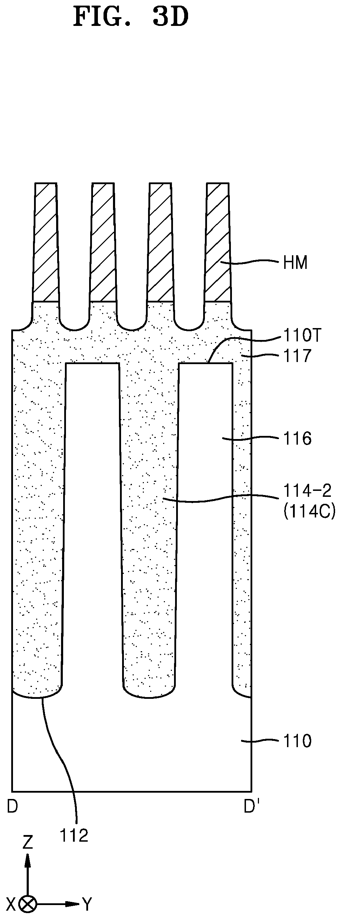

In FIG. 3A and 3D, the second field insulating layer 114-2 may include a third subfield insulating layer 114C. In some embodiments, the second field insulating layer 114-2 may include a single third subfield insulating layer 114C. The third subfield insulating layer 114C may include the same material as that of the first subfield insulating layer 114A. For example, the third subfield insulating layer 114C may include a silicon oxide layer.

A buffer insulating layer 117 is formed on the active regions 116 and the first field insulating layers 114-1 and the second field insulating layer 114-2. The buffer insulating layer 117 may include the same material as that of the second field insulating layer 114-2. In FIGS. 3A to 3D, the buffer insulating layer 117 and the second field insulating layer 114-2 include the same material, so that a boundary line between the buffer insulating layer 117 and the second field insulating layer 114-2 is not indicated.

The hard mask patterns HM are formed on the buffer insulating layer 117. The hard mask patterns HM are formed to define the word lines (WL of FIG. 1). The hard mask patterns HM do not overlap the word lines (WL of FIG. 1) as described above with reference to FIG. 2, but are arranged to extend to be parallel to each other in the first direction (the X direction) between the word lines (WL of FIG. 1).

Subsequently, the buffer insulating layer 117 is etched using the hard mask patterns HM as an etch mask to form a patterned buffer insulating layer 117. The patterned buffer insulating layer 117 may act as a mask pattern in a subsequent process. In FIG. 3A, the hard mask patterns HM entirely cover the patterned buffer insulating layer 117, and in FIG. 3B, the patterned buffer insulating layer 117 is exposed to the outside. In FIGS. 3C and 3D, the hard mask patterns HM are apart from each other on the patterned buffer insulating layer 117.

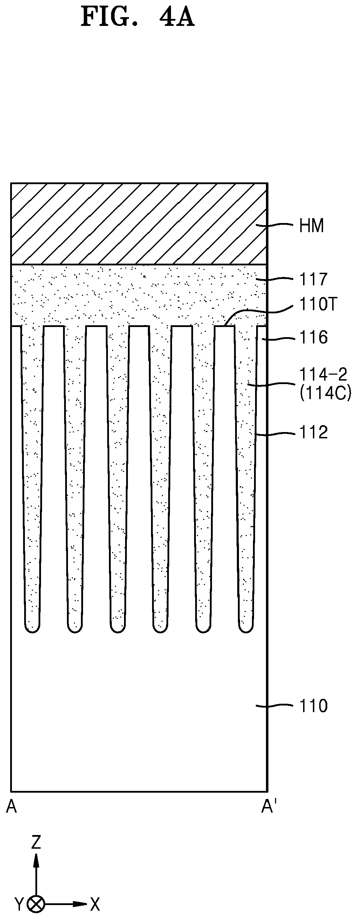

In FIGS. 4A to 4D, gate trenches 118 are formed by etching the patterned buffer insulating layer 117, the active regions 116, the first field insulating layer 114-1, and the second field insulating layer 114-2 by using the hard mask patterns HM as an etch mask. The gate trenches 118 may be word line trenches.

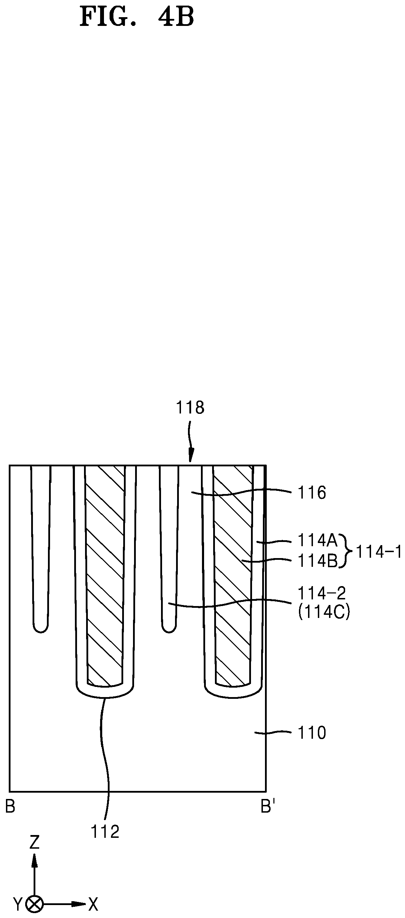

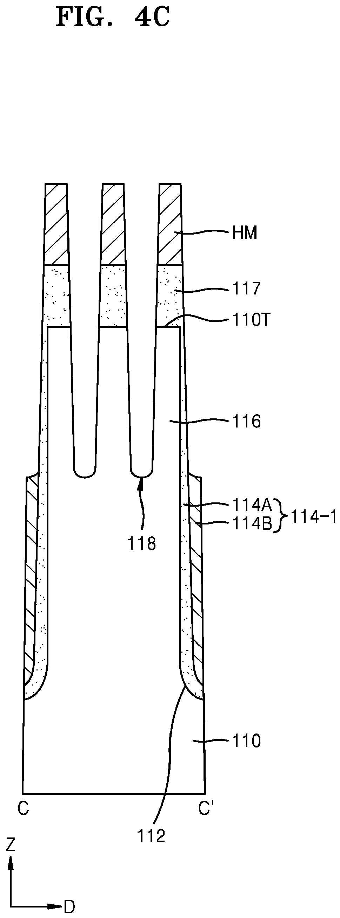

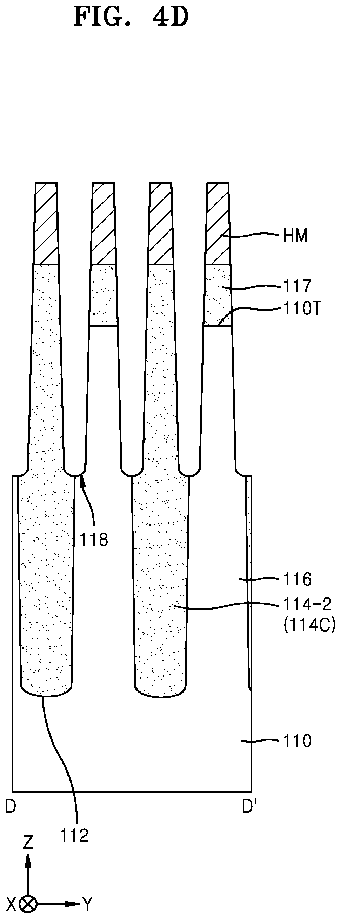

In FIG. 4A, the hard mask patterns HM entirely cover the patterned buffer insulating layer 117, and as shown in FIG. 4B, the active regions 116 and the first field insulating layer 114-1 and the second field insulating layer 114-2 may be exposed to the outside. In FIGS. 4C and 4D, gate trenches 118 are apart from each other in the patterned buffer insulating layer 117 and the active regions 116. In addition, as shown in FIGS. 4B and 4C, the gate trenches 118 may be formed at a level lower than that of the surface 110T (or the upper surface) of the substrate 110.

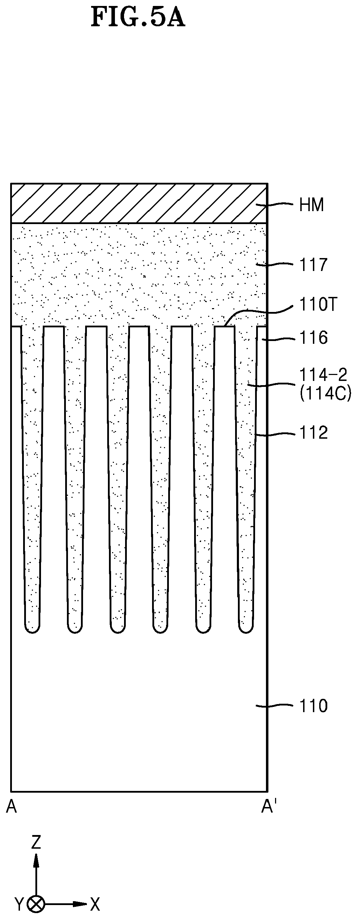

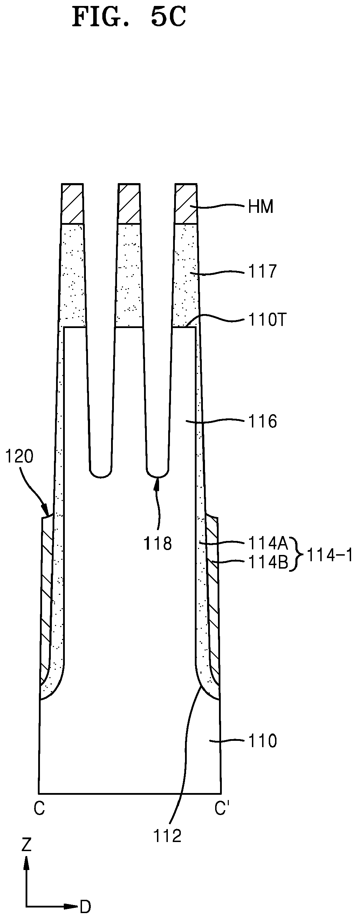

In FIGS. 5A to 5D, the first field insulating layer 114-1 and the second field insulating layer 114-2 are primarily etched using the hard mask patterns HM as an etch mask to form a first field recess hole 120 and a second field recess hole 122. In some embodiments, the primary etching may be performed as a wet etching method or a dry etching method. The first field recess hole 120 and the second field recess hole 122 may be formed by recess-etching upper portions of the first field insulating layer 114-1 and the second field insulating layer 114-2. Lower surfaces of the first field recess hole 120 and the second field recess hole 122 may be located at a level lower than that of the surface of the active regions 116.

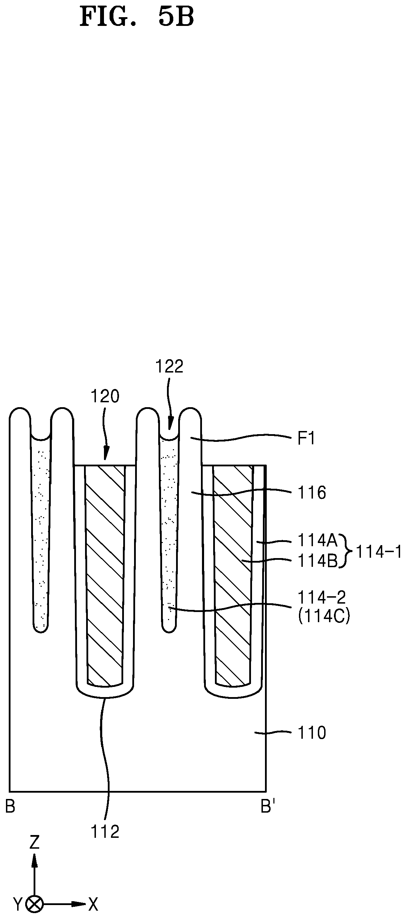

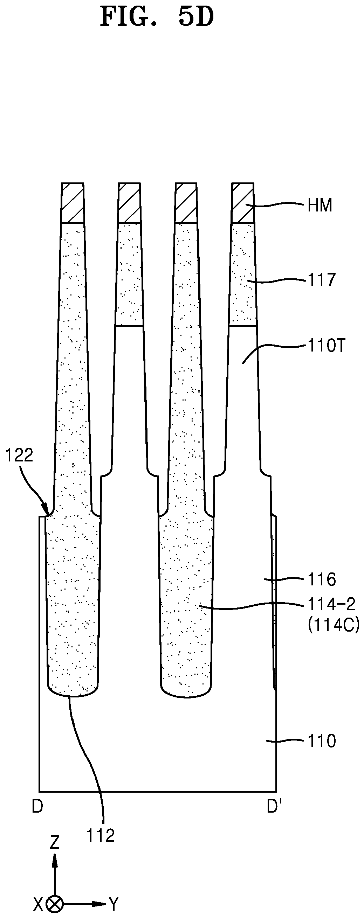

As shown in FIG. 5B, the first field recess hole 120 may be formed by etching the first field insulating layer 114-1. As shown in FIGS. 5B and 5D, the second field recess hole 122 may be formed by etching the second field insulating layer 114-2.

In some embodiments, a surface of the first field recess hole 120 may have a flat shape, e.g., a flat surface, and a surface of the second field recess hole 122 may have a concave shape, e.g., a concave surface. In addition, due to the formation of the first field recess hole 120 and the second field recess hole 122, the active regions 116 may be exposed more than the surfaces of the first field insulating layer 114-1 and the second field insulating layer 114-2 to form first active fins F1.

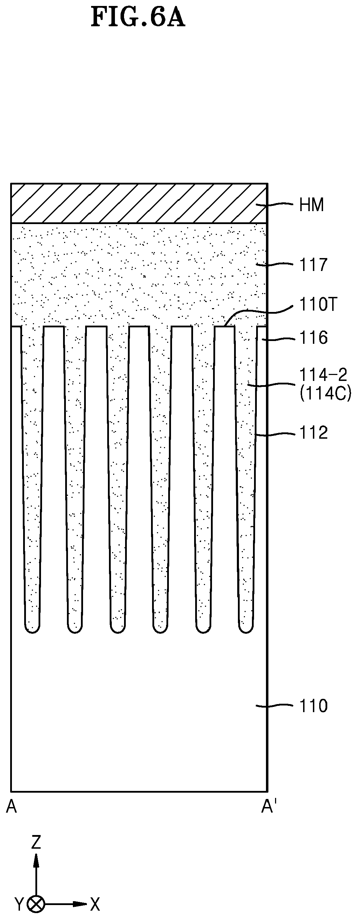

In FIGS. 6A to 6D, the primarily etched first field insulating layer 114-1 and the second field insulating layer 114-2 are secondarily etched using the hard mask patterns HM as an etch mask to form a third field recess hole 124 and a fourth field recess hole 126. In some embodiments, the secondary etching may be performed as a wet etching method or a dry etching method. In some embodiments, the secondary etching may be performed as a non-plasma-based dry etching method. In some embodiments, the secondary etching may be performed as a Chemical Oxide Removal (COR) method. The COR method may be a Silicon Oxide etching method using HF and NH₃ gas.

The third field recess hole 124 and the fourth field recess hole 126 may be formed by recess-etching upper portions of the primarily etched first field insulating layer 114-1 and the second field insulating layer 114-2. Lower surfaces of the third field recess hole 124 and the fourth field recess hole 126 may be located at a level lower than that of the surface of the active regions 116.

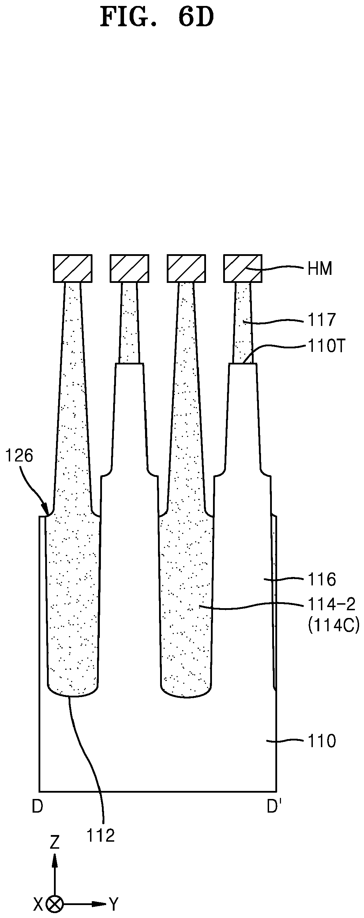

As shown in FIG. 6B, the third field recess hole 124 may be formed by etching the primarily-etched first subfield insulating layer 114A. As shown in FIGS. 6B and 6D, the fourth field recess hole 126 may be formed by etching the primarily-etched second field insulating layer 114-2, e.g., the third subfield insulating layer 114C.

In some embodiments, as shown in FIG. 6B, a surface of the third field recess hole 124 may have a concave shape, e.g., a concave surface, and a surface of the fourth field recess hole 126 may have a concave shape, *e.g.,* a concave surface. The surface of the third field recess hole 124 may be located at a level lower than that of the surface of the first field recess hole 120.

In addition, due to the formation of the third field recess hole 124 and the fourth field recess hole 126, the active regions 116 may protrude from the surfaces of the first field insulating layer 114-1 and the second field insulating layer 114-2 to form second active fins F2.

Here, a relationship of the first field insulating layer 114-1 and the second field insulating layer 114-2, the first field recess hole 120, the third field recess hole 124, the fourth field recess hole 126, the active regions 116, and the second active fins F2 is described in more detail with reference to FIGS. 6B and 7. An enlarged view EN1 of FIG. 7 may be a cross-sectional view of a partial region of FIG. 6B.

As shown in FIGS. 6B and 7, the first field insulating layer 114-1 may be located in a region RG1 having a large distance between the outermost portions of the second active fins F2 located on the active regions 116. The second subfield insulating layer 114B constituting the first field insulating layer 114-1 may have a first width W1. The first subfield insulating layer 114A constituting the first field insulating layer 114-1 may have a second width W2 that is less than the first width W1. As a result, the first field insulating layer 114-1 may have a third width W3. In some embodiments, the first width W1, the second width W2, and the third width W3 may be several nm to several tens of nm.

The second field insulating layer 114-2 may be disposed in a region RG2 having a small distance between the outermost portions of the second active fins F2 located on the active regions 116. The second field insulating layer 114-2 may include the third subfield insulating layer 114C. The third subfield insulating layer 114C constituting the second field insulating layer 114-2 may have a fourth width W4. The fourth width W4 may be greater than the second width W2 and less than the first width W1. In some embodiments, the fourth width W4 may be several nm to several tens of nm.

A surface 120T of the first field recess hole 120 may have a flat shape, e.g., a flat surface. A surface 124T of the third field recess hole 124 may have a concave shape, e.g., a concave surface. A surface 126T of the fourth field recess hole 126 may have a concave shape, e.g., a concave surface.

In other words, a surface 114AT1 of the first subfield insulating layer 114A may have a concave shape, e.g., a concave surface. A surface 114BT of the second subfield insulating layer 114B may have a flat shape, e.g., a flat surface. A surface 114CT1 of the third subfield insulating layer 114C may have a concave shape, e.g., a concave surface.

The fourth field recess hole 126 may have a first depth d1 from the surface 120T of the first field recess hole 120. The third field recess hole 124 may have a second depth d2, less than the first depth d1, from the surface 120T of the first field recess hole 120. In some embodiments, the first depth d1 and the second depth d2 may be several nm to several tens of nm.

The active regions 116 may protrude from the surfaces of the first field insulating layer 114-1 and the second field insulating layer 114-2 to form the second active fins F2. The second active fins F2 may have the same body as the active regions 116. The second active fins F2 may have a first height H1 from a surface 114CT1 of the third subfield insulating layer 114C to the uppermost end FT1. In the IC semiconductor device as described above, the first height H1 of the second active fins F2 may be adjusted by adjusting the first depth d1 of the fourth field recess hole 126.

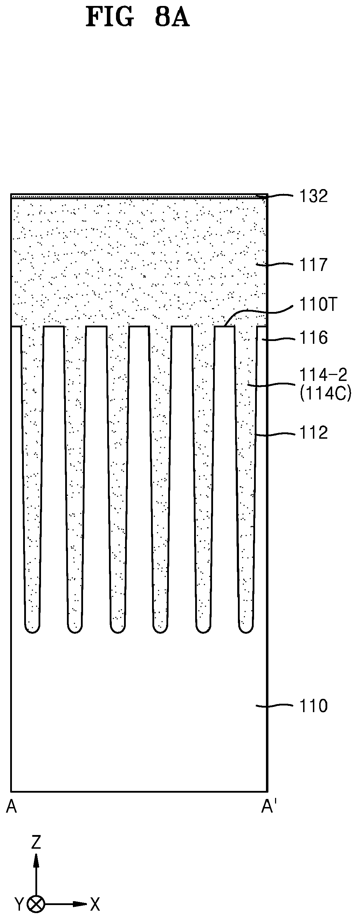

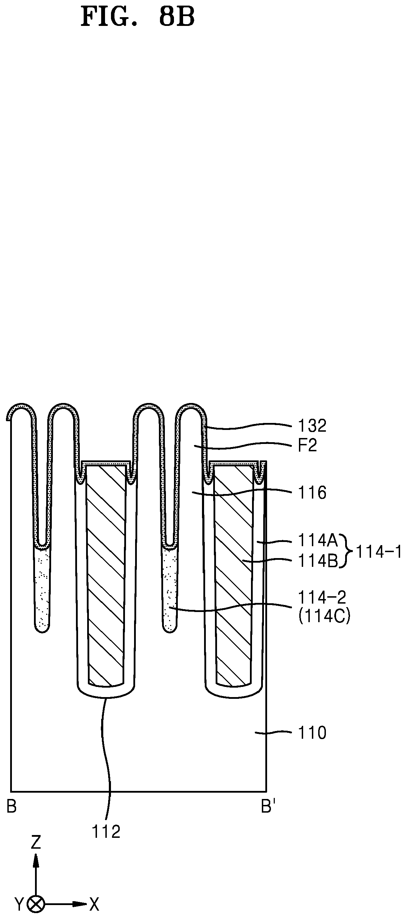

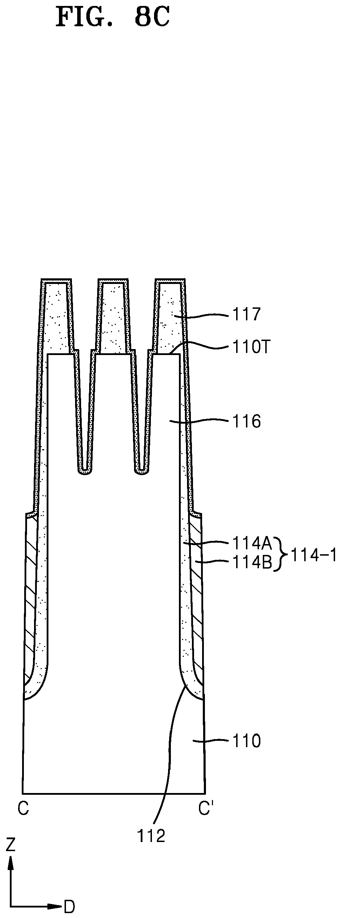

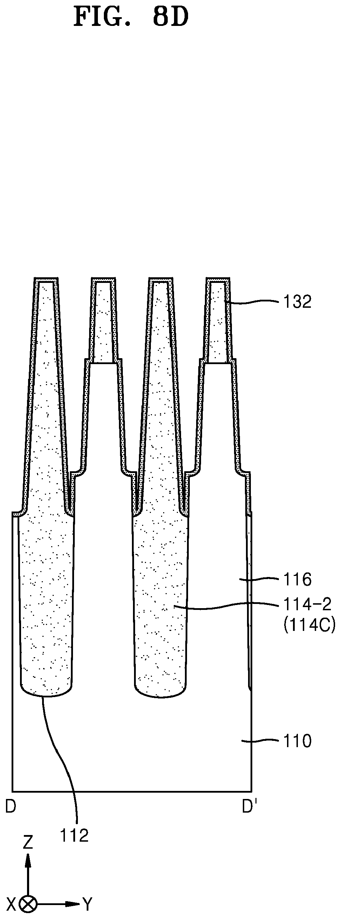

In FIGS. 8A to 8D, the hard mask patterns HM are removed. Subsequently, a gate insulating layer 132 is formed on the patterned buffer insulating layer 117, the second active fins F2, the active regions 116, and the first field insulating layer 114-1 and the second field insulating layer 114-2. As shown in FIG. 8B, the gate insulating layer 132 is formed to cover the second active fins F2.

The gate insulating layer 132 may include at least one selected from a silicon oxide layer, a silicon nitride layer, a silicon oxynitride layer, an Oxide/Nitride/Oxide (ONO), or a high-k dielectric film having a higher dielectric constant than that of the silicon oxide layer. For example, the gate insulating layer 132 may have a dielectric constant of about 10 to about 25.

In some embodiments, the gate insulating layer 132 may include at least one material selected from Hafnium Oxide (HfO₂), Hafnium Silicon Oxide (HfSiO), Hafnium Oxynitride (HfON), Hafnium Silicon Oxynitride (HfSiON), Lanthanum Oxide (La₂O₃), Lanthanum Aluminum Oxide (LaAlOs), Zirconium Oxide (ZrO₂), Zirconium Silicon Oxide (ZrSiₓO_{y}), Zirconium Oxynitride (ZrOₓN_{y}), Zirconium Silicon Oxynitride (ZrSiOₓN_{y}), Tantalum Oxide (Ta₂O₅), Titanium Oxide (TiO₂), Barium Strontium Titanium Oxide (BaSrTiOₓ), Barium Titanium Oxide (BaTiO₃), Strontium Titanium Oxide (SrTiO₃), Yttrium Oxide (Y₂O₃), Aluminum Oxide (Al₂O₃), and Lead Scandium Tantalum Oxide (Pb₂ScTaO₆). In some embodiments, the gate insulating layer 132 may include HfO₂, Al₂O3, Ta₂O₃, or TiO₂.

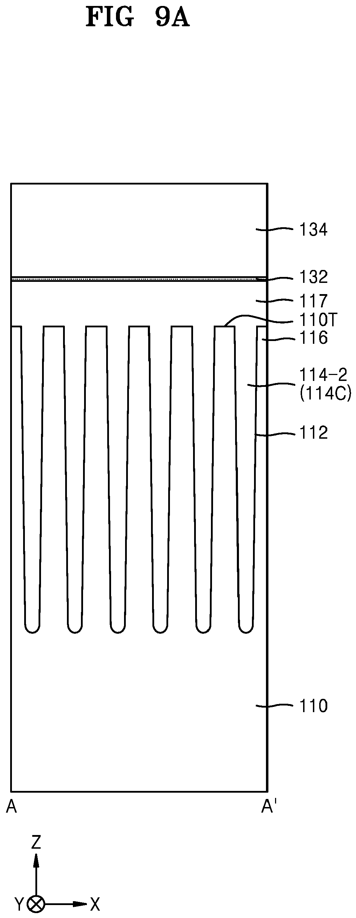

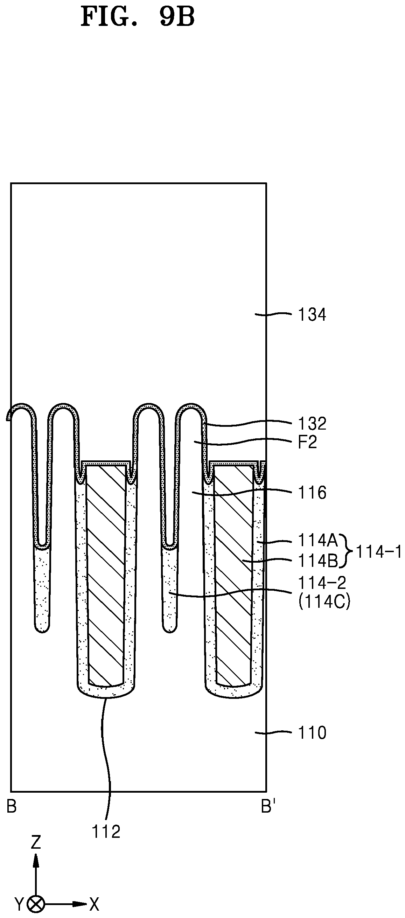

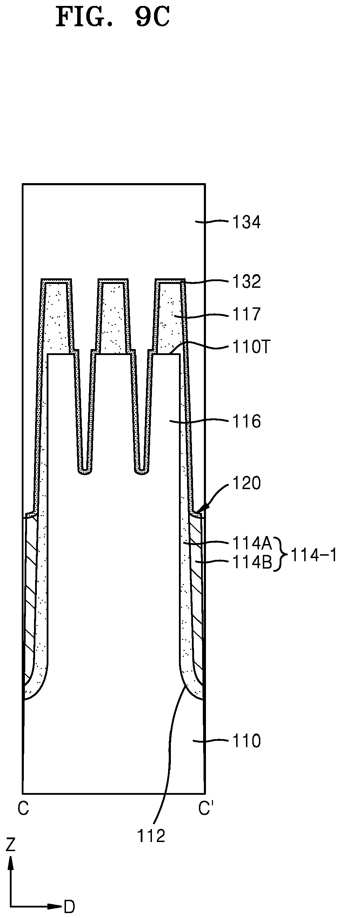

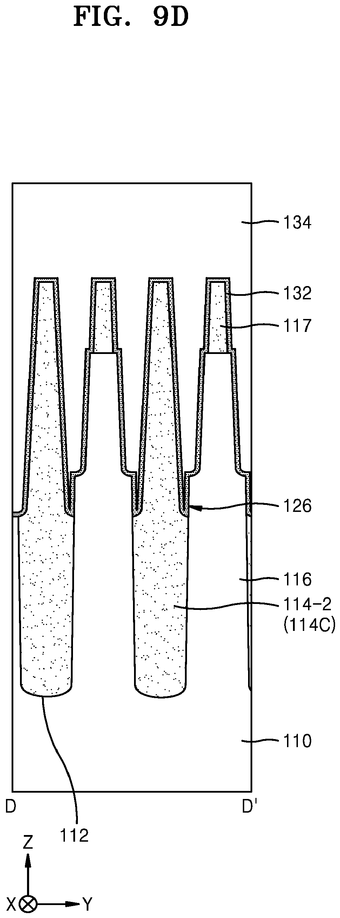

In FIGS. 9A to 9D, a gate material layer 134 is formed on the gate insulating layer 132. In FIG. 9B, the gate material layer 134 may be formed to sufficiently cover the second active fins F2 on the gate insulating layer 132. In FIGS. 9C and 9D, the gate material layer 134 may be formed to sufficiently cover the active regions 116, the patterned buffer insulating layer 117, the first field recess hole 120, and the fourth field recess hole 126 on the gate insulating layer 132.

The gate material layer 134 may include a metal layer or a metal nitride layer. In some embodiments, the gate material layer 134 may include at least one material selected from Ti, TiN, Ta, TaN, W, WN, TiSiN, and WSiN.

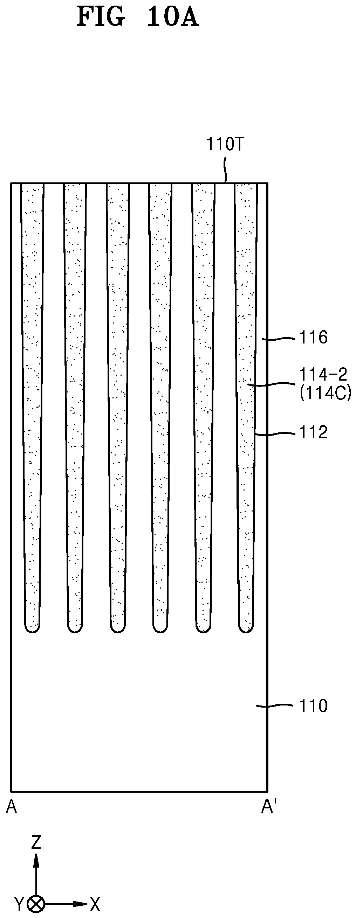

In FIGS. 10A to 10D, the gate material layer 134 is etched back to form a gate electrode 138. The gate material layer 134 may be etched back using a wet etching method or a dry etching method. The gate electrode 138 serves as the word lines WL of FIG. 1 described above.

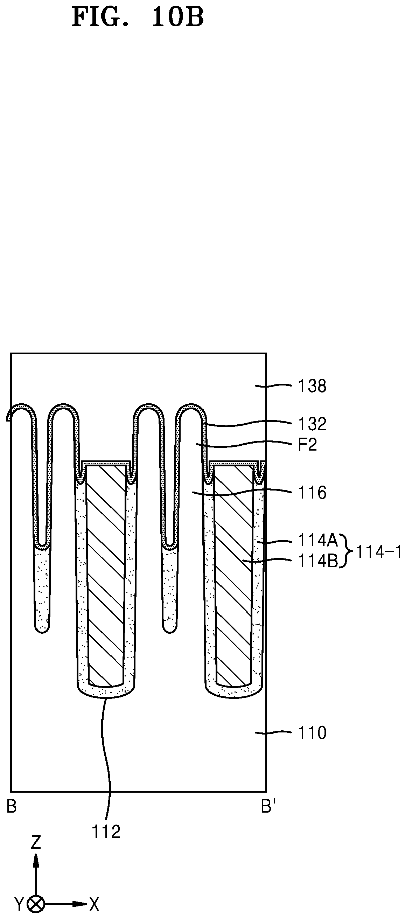

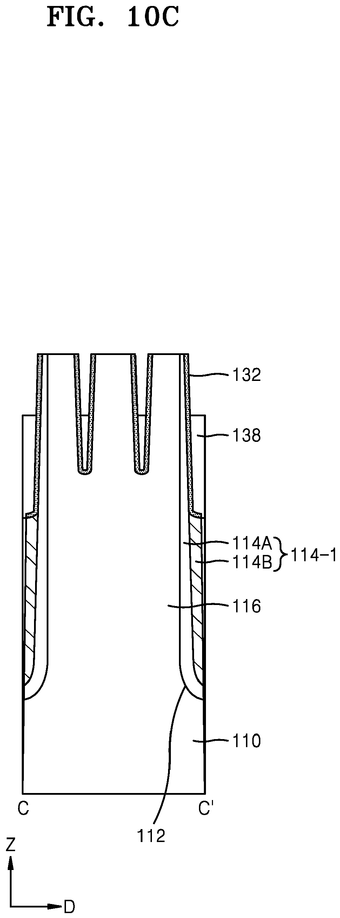

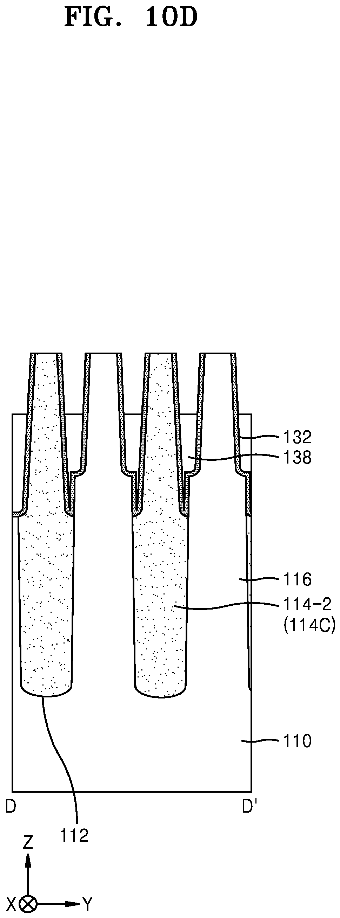

In FIG. 10A, the gate material layer 134, the gate insulating layer 132, and the patterned buffer insulating layer 117 may be etched back to expose the surface (110T or the upper surface) of the substrate 110. The upper surface of the gate electrode 138 of FIG. 10B may be at a lower level than that of the surface 110T of the substrate 110 of FIG. 10A. In FIGS. 10C and 10D, the gate electrode 138 may be formed at a level lower than that of the upper surface of the active regions 116.

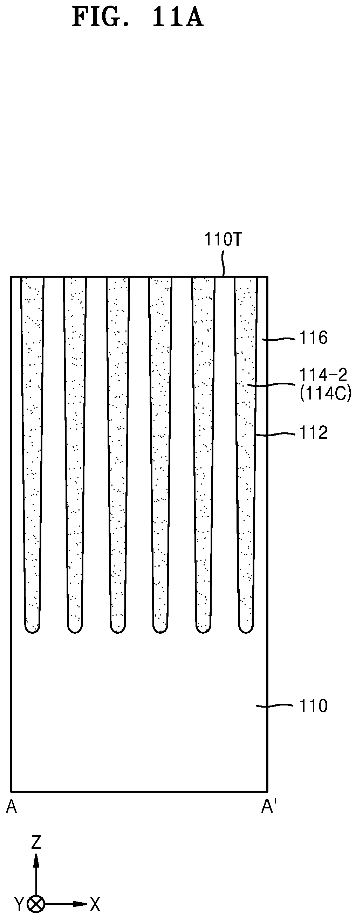

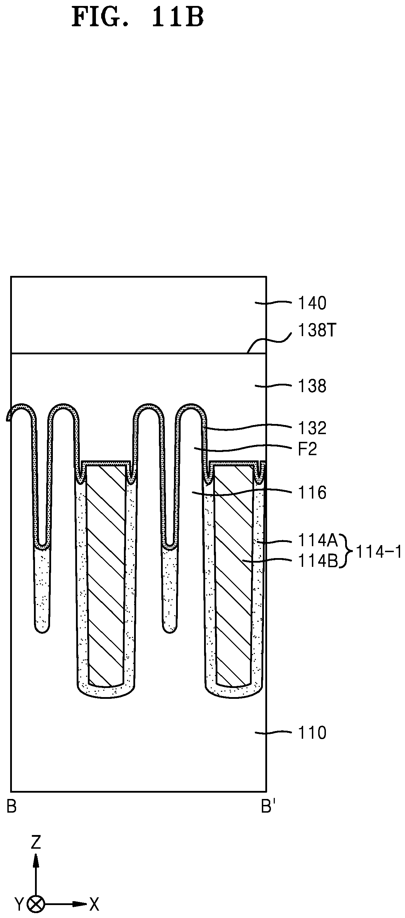

In FIGS. 11A to 11D, a buried insulating layer 140 is formed on the gate electrode 138. The buried insulating layer 140 may include a Silicon Nitride layer. As shown in FIG. 11B, the buried insulating layer 140 is formed on the gate electrode 138 on the second active fins F2. An upper surface 138T of the gate electrode 138 may be located at a level lower than that of the buried insulating layer 140. In addition, a lower surface of the gate electrode 138, e.g., upper surfaces of the active regions 116 and the second active fins F2, may have a concavo-convex shape.

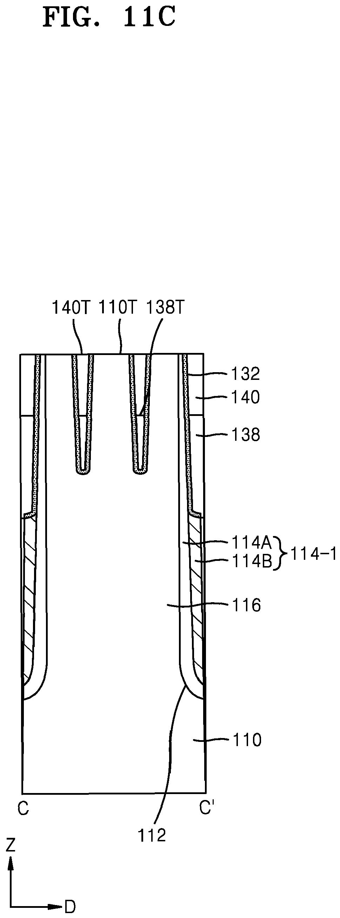

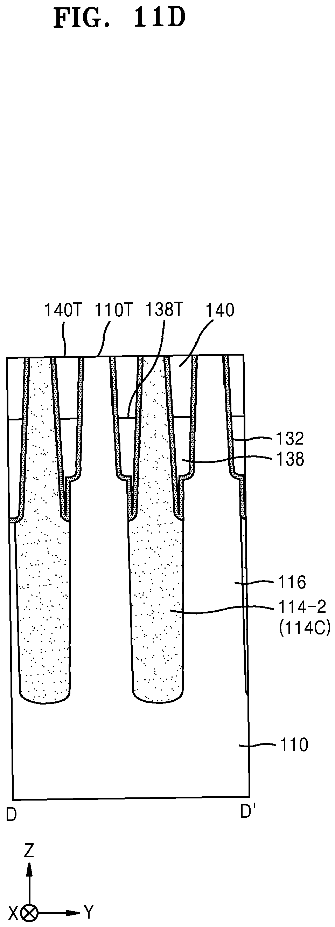

As shown in FIGS. 11C and 11D, the buried insulating layer 140 may be formed between the active regions 116 and between the first field insulating layer 114-1 and the second field insulating layer 114-2 and the active regions 116. An upper surface 140T of the buried insulating layer 140 may be located at the same level as that of the surface 110T (or the upper surface) of the substrate 110. An upper surface 138T of the gate electrode 138 may be located at a level lower than that of the surface 110T (or the upper surface) of the substrate 110. In the method of manufacturing an IC semiconductor device described above, a description of forming a source/drain region is omitted for convenience.

By the method of manufacturing an IC semiconductor device as described above, the active regions 116, the second active fins F2, the gate insulating layer 132, and the gate electrode 138 may constitute a finFET. The active regions 116, the second active fins F2, the gate insulating layer 132, and the gate electrode 138 may constitute a saddle finFET having a saddle fin structure. In addition, the active regions 116, the second active fins F2, the gate insulating layer 132, and the gate electrode 138 may constitute a Buried Channel Array Transistor (BCAT).

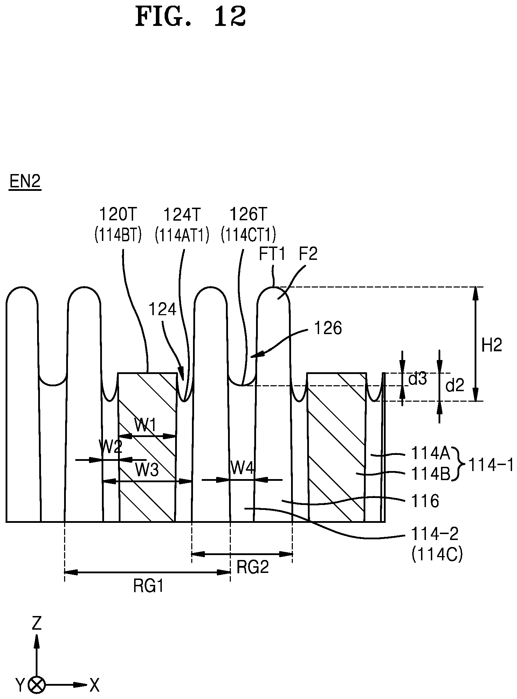

FIG. 12 is an enlarged cross-sectional view EN2 of an IC semiconductor device according to an embodiment. The enlarged cross-sectional view EN2 of FIG. 12 may be the same as that of FIG. 7, except that the fourth field recess hole 126 has a third depth d3. The enlarged cross-sectional view EN2 of FIG. 12 may be a modified example of a partial region of FIG. 6B. In FIG. 12, the same reference numerals as those of FIGS. 6B and 7 denote the same members. In FIG. 12, the same descriptions as those given above with reference to FIGS. 6B and 7 are briefly given or omitted.

The third field recess hole 124 may have a second depth d2, less than the first depth d1, from the surface 120T of the first field recess hole 120 as described above with reference to FIGS. 6B and 7. The fourth field recess hole 126 may have a third depth d3, less than the second depth d2, from the surface 120T of the first field recess hole 120. The third depth d3 may be several nm to several tens of nm.

The third subfield insulating layer 114C constituting the second field insulating layer 114-2 may have a fourth width W4. The fourth width W4 may be greater than the second width W2 and less than the first width W1. In some embodiments, the fourth width W4 may be several nm to several tens of nm. The surface 126T of the fourth field recess hole 126 may have a concave shape, e.g., a concave surface. The surface 114CT1 of the third subfield insulating layer 114C may have a concave shape, e.g., a concave surface.

The active regions 116 may protrude from the surfaces of the first field insulating layer 114-1 and the second field insulating layer 114-2 to form the second active fins F2. The second active fins F2 may have a second height H2 from the surface 114AT1 of the first subfield insulating layer 114A to the uppermost end FT1. In the IC semiconductor device as described above, the second height H2 of the second active fins F2 may be adjusted by adjusting the second depth d2 of the third field recess hole 124.

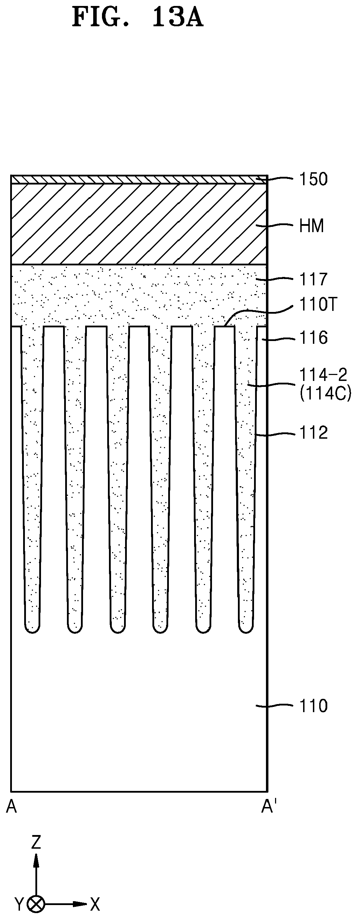

FIGS. 13A to 18D are cross-sectional views illustrating a method of manufacturing an IC semiconductor device and an IC semiconductor device manufactured by the method according to an embodiment. FIGS. 13A to 18D may be substantially the same as FIGS. 3A to 11D, except that a protective layer 150 and a protective pattern 152 are further formed during a manufacturing process. In FIGS. 13A to 18D, the same reference numerals as those of FIGS. 3A to 11D denote the same members. In FIGS. 13A to 18D, the same descriptions as those given above with reference to FIGS. 3A to 11D are briefly given or omitted.

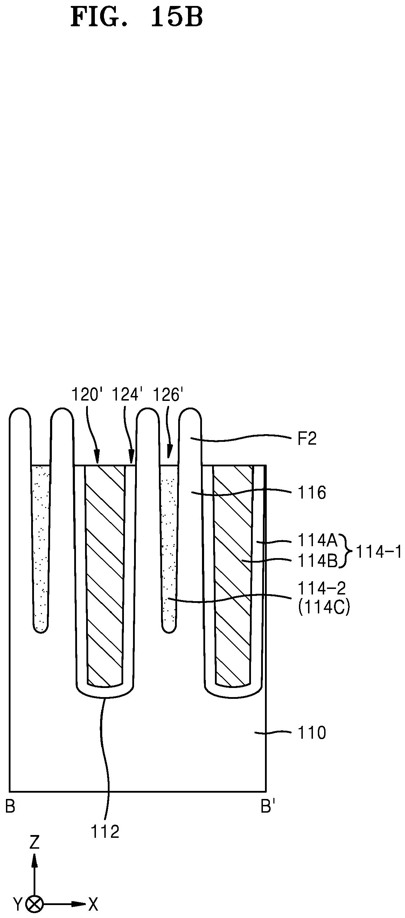

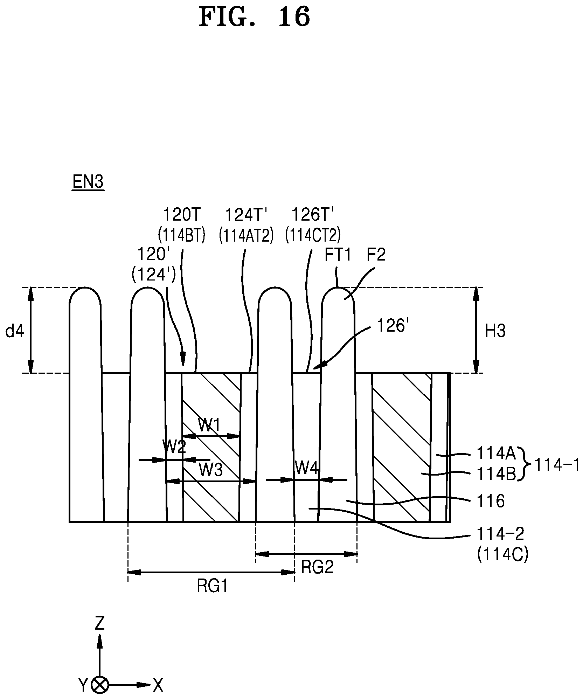

FIGS. 13A to 15A and FIGS. 17A and 18A are cross-sectional views taken along line A-A' of FIG. 2, FIGS. 13B to 15B and FIGS. 17B and 18B are cross-sectional views taken along line B-B' of FIG. 2, FIGS. 13C to 15C and FIGS. 17C and 18C are cross-sectional views taken along line C-C' of FIG. 2, and FIGS. 13D to 15D and FIGS. 17D and 18D are cross-sectional views taken along line D-D' of FIG. 2. A cross-sectional view EN3 of FIG. 16 is a partially enlarged cross-sectional view of FIG. 15B.

In FIGS. 13A to 13D, the processes of FIGS. 3A to 3D and FIGS. 4A to 4D described above are performed. Subsequently, the protective layer 150 is formed on the hard mask patterns HM, the patterned buffer insulating layer 117, the active regions 116, and the field insulating layers 114-1 and 114-2. The protective layer 150 may include a silicon nitride layer.

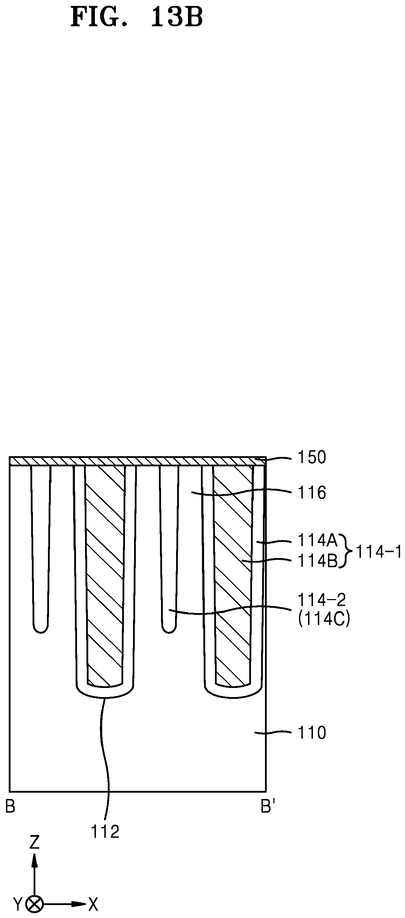

In FIG. 13A, the protective layer 150 may be formed on the hard mask patterns HM. In FIG. 13B, the protective layer 150 is formed on the active regions 116 and the first field insulating layer 114-1 and the second field insulating layer 114-2 in the gate trenches (118 of FIG. 4B).

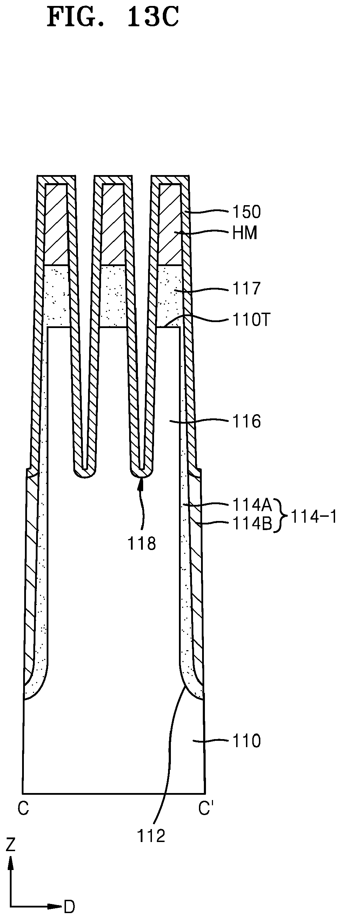

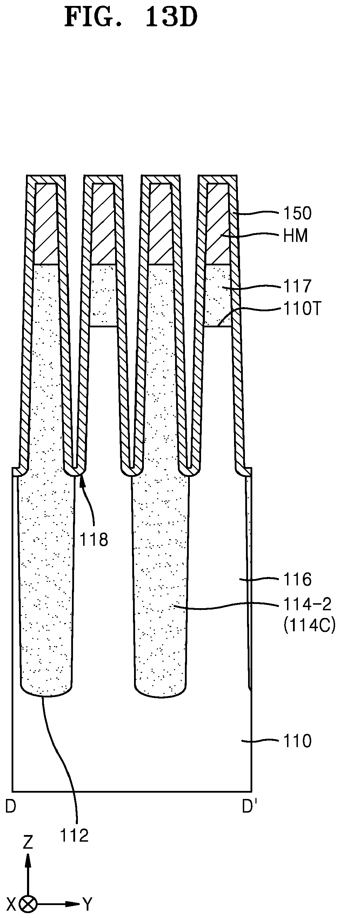

In FIGS. 13C and 13D, the protective layer 150 is formed in the gate trenches 118 and on the patterned buffer insulating layer 117, the active regions 116, and the first field insulating layer 114-1 and the second field insulating layer 114-2.

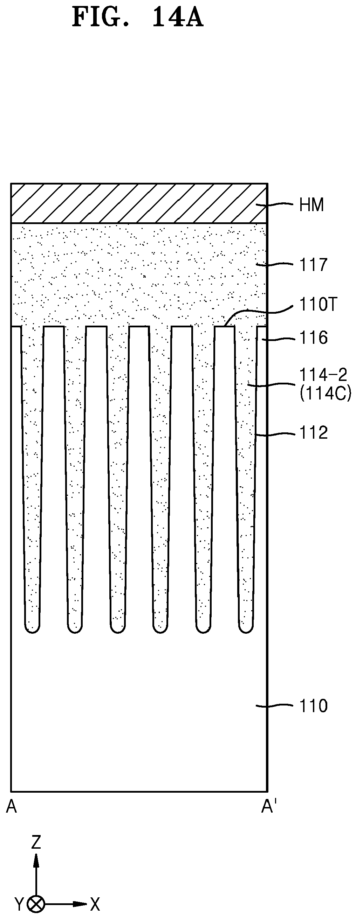

In FIGS. 14A to 14D, similarly to FIGS. 5A to 5D, the first field insulating layer 114-1 and the second field insulating layer 114-2 are primarily etched using the hard mask patterns HM and the protective layer 150 as an etch mask to form a first field recess hole 120' and a second field recess hole 122. A lower portion of the protective layer 150 is primarily etched using the hard mask patterns HM as an etch mask to form a protective pattern 152 and upper portions of the first field insulating layer 114-1 and the second field insulating layer 114-2 are primarily etched to form a first field recess hole 120' and the second field recess hole 122.

In some embodiments, the primary etching may be performed as a wet etching method or a dry etching method. The first field recess hole 120' and the second field recess hole 122 may be formed by recess-etching upper portions of the first field insulating layer 114-1 and the second field insulating layer 114-2. Lower surfaces of the first field recess hole 120' and the second field recess hole 122 may be located at a level lower than that of the surface of the active regions 116.

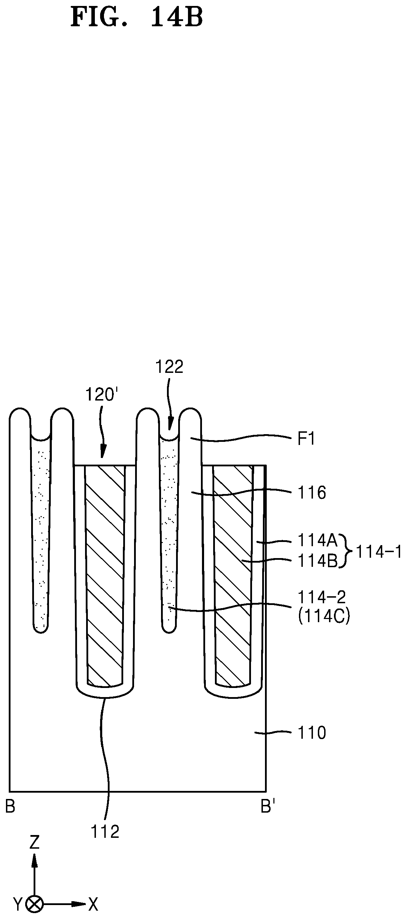

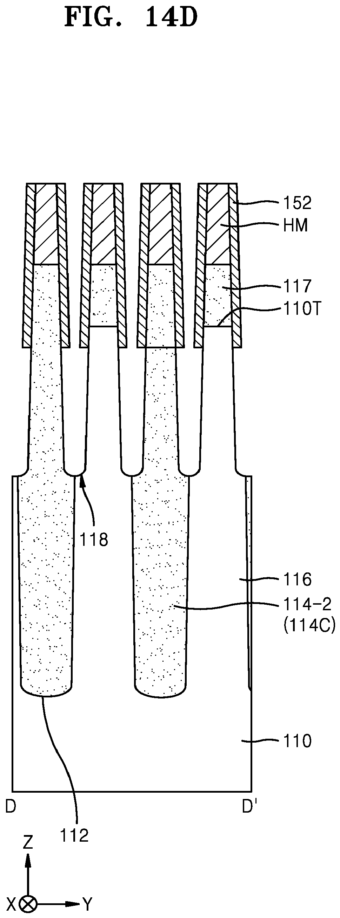

As shown in FIG. 14B, due to the formation of the first field recess hole 120' and the second field recess hole 122, the active regions 116 may be exposed more than the surfaces of the first field insulating layer 114-1 and the second field insulating layer 114-2 to form the first active fins F1. As shown in FIG. 14D, the second field recess hole 122 may not be formed in the second field insulating layer 114-2 due to the protective layer (150 of FIG. 13D).

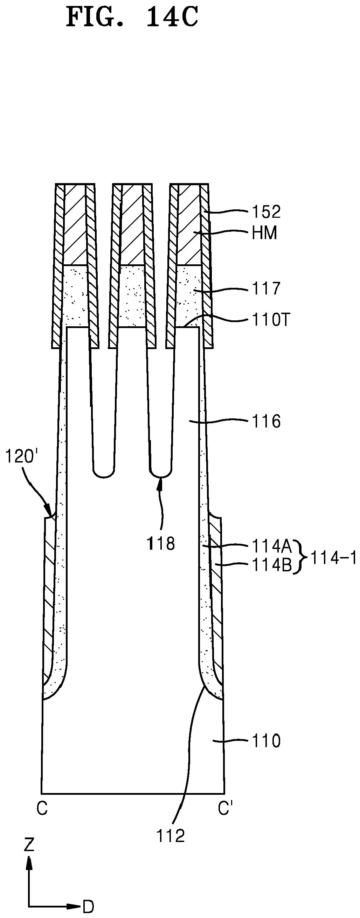

As shown in FIGS. 14C and 14D, etching loss on both sides of upper portions of the patterned buffer insulating layer 117 and the active regions 116 may be prevented when a lower portion of the protective layer 150 is etched using the hard mask patterns HM as an etch mask. Accordingly, a subsequent process (e.g., a bit line forming process or a capacitor electrode forming process) may be easily performed.

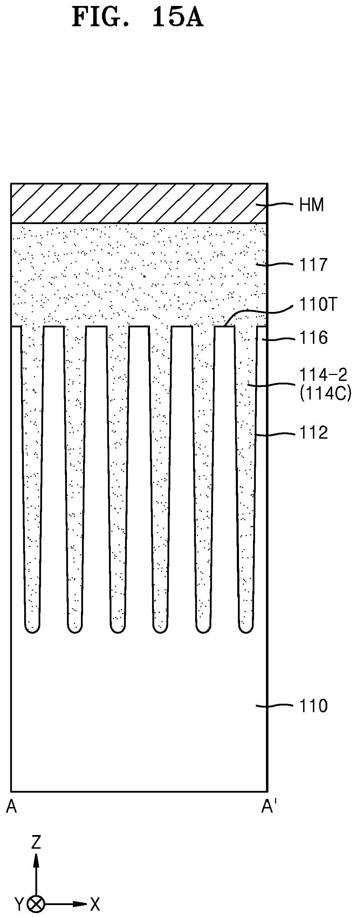

In FIGS. 15A to 15D, similarly to FIGS. 6A to 6D, the primarily etched first field insulating layer 114-1 and the second field insulating layer 114-2 are secondarily etched using the hard mask patterns HM and the protective pattern 152 as an etch mask to form a third field recess hole 124' and a fourth field recess hole 126'.

In some embodiments, the secondary etching may be performed as a wet etching method or a dry etching method. In some embodiments, the secondary etching may be performed as a non-plasma-based dry etching method. In some embodiments, the secondary etching may be performed as a COR method. The COR method may be a silicon oxide etching method using HF and NH₃ gas.

In some embodiments, as shown in FIG. 15B, the third field recess hole 124' may have the same surface as the first field recess hole 120'. When the third field recess hole 124' is formed, an upper portion of the first subfield insulating layer 114A may not be etched. Accordingly, a surface of the third field recess hole 124' may have a flat shape, e.g., a flat surface.

In some embodiments, unlike in FIG. 15B, the surface of the third field recess hole 124' may be located at a level lower than that of the surface of the first field recess hole 120' as in the previous embodiment When the third field recess hole 124' is formed, an upper portion of the first subfield insulating layer 114A may be etched. Accordingly, the surface of the third field recess hole 124' may have a concave shape, e.g., a concave surface.

As shown in FIG. 15B, the fourth field recess hole 126' may be formed by recess-etching an upper portion of the primarily etched second field insulating layer 114-2, e.g., the third subfield insulating layer 114C. A lower surface of the fourth field recess hole 126' may be located at a level lower than that of the surface of the active regions 116. In some embodiments, as shown in FIG. 15B, the surface of the fourth field recess hole 126' may have a flat shape, e.g., a flat surface. Surfaces of the first field recess hole 120', the third field recess hole 124', and the fourth field recess hole 126' may be located at the same level.

In addition, due to the formation of the first field recess hole 120' and the fourth field recess hole 126', the active regions 116 may protrude from the surfaces of the first field insulating layer 114-1 and the second field insulating layer 114-2 to form the second active fins F2.

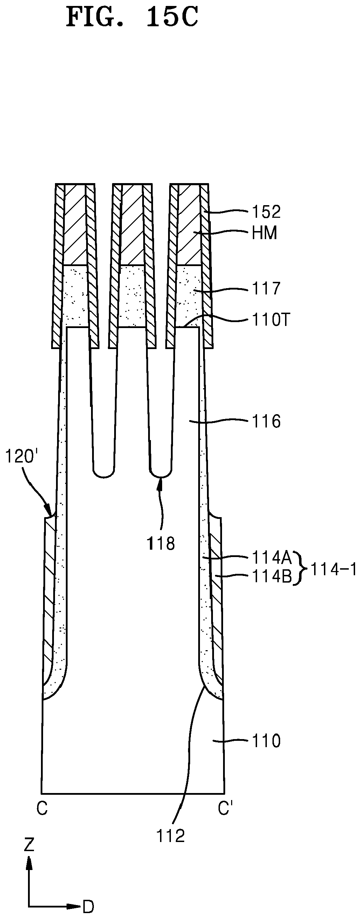

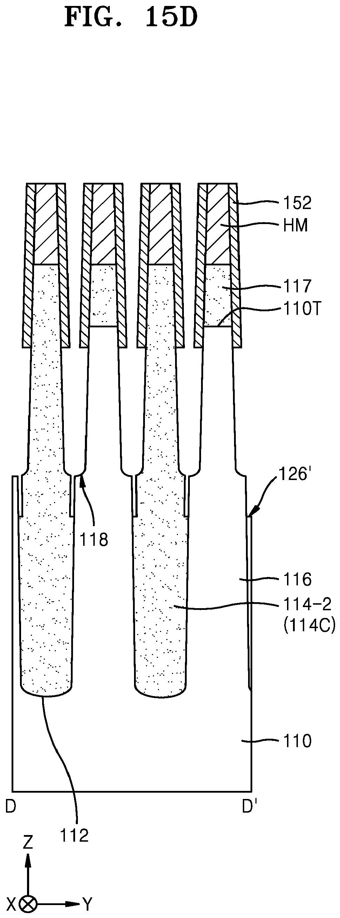

As shown in FIGS. 15C and 15D, etching loss on both sides of upper portions of the patterned buffer insulating layer 117 and the active regions 116 may be prevented when the first field insulating layer 114-1 and the second field insulating layer 114-2 are secondarily etched using the hard mask patterns HM and the protective pattern 152 as an etch mask. Accordingly, a subsequent process, e.g., a bit line forming process or a capacitor electrode forming process, may be easily performed.

Here, a relationship of the first field insulating layer 114-1 and the second field insulating layer 114-2, the first field recess hole 120', the third field recess hole 124', the fourth field recess hole 126', the active regions 116, and the second active fins F2 is described in more detail with reference to FIGS. 15B to 16. The enlarged cross-sectional view EN3 of FIG. 16 may be a cross-sectional view of a partial region of FIG. 15B. In the enlarged cross-sectional view EN3 of FIG. 16, the same or similar descriptions as those given above with reference to FIG. 12 are briefly given or omitted.

As shown in FIGS. 15B and 16, the surface 120T of the first field recess hole 120' may have a flat shape, e.g., a flat surface. A surface 124T' of the third field recess hole 124' may have a flat shape, e.g., a flat surface. A surface 126T' of the fourth field recess hole 126' may have a flat shape, e.g., a flat surface.

In other words, the surface 114BT of the second subfield insulating layer 114B and the surface 114AT2 of the first subfield insulating layer 114A may have a flat shape, e.g., a flat surface. The surface 114CT2 of the third subfield insulating layer 114C may have a flat shape, e.g., a flat surface. Surfaces of the first field recess hole 120', the third field recess hole 124', and the fourth field recess hole 126' may have the same level.

The first field recess hole 120', the third field recess hole 124', and the fourth field recess hole 126' may have a fourth depth d4 from the uppermost end FT1 of the second active fins F2 to the surface 114BT of the second subfield insulating layer 114B, the surface 114AT2 of the first subfield insulating layer 114A, and the surface 114CT2 of the third subfield insulating layer 114C. In some embodiments, the fourth depth d4 may be several nm to several tens of nm.

The active regions 116 may protrude from the surfaces of the first field insulating layer 114-1 and the second field insulating layer 114-2 to form the second active fins F2. The second active fins F2 may have a third height H3 from the surface 114BT of the second subfield insulating layer 114B, the surface 114AT2 of the first subfield insulating layer 114A, and the surface 114CT2 of the third subfield insulating layer 114C to the uppermost end FT1. The fourth depth d4 and the third height H3 may have the same value.

In the IC semiconductor device as described above, the third height H3 of the second active fins F2 may be adjusted by adjusting the fourth depth d4 of the first field recess hole 120', the third field recess hole 124', and the fourth field recess hole 126'.

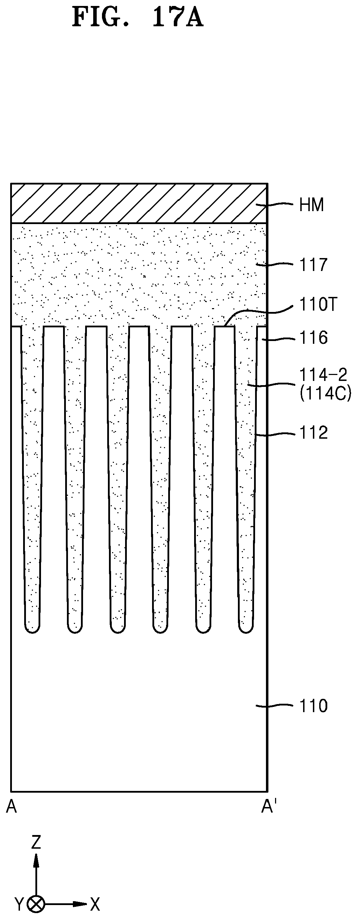

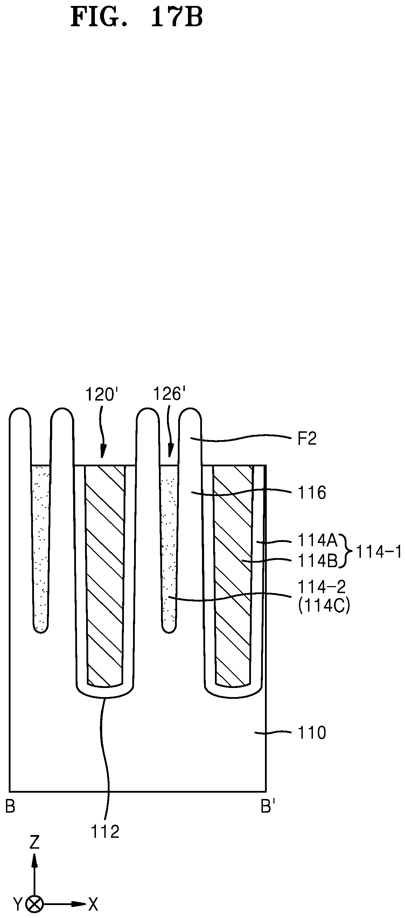

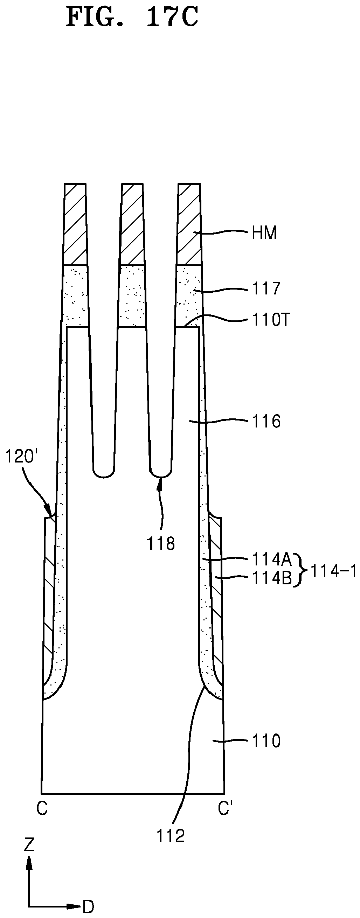

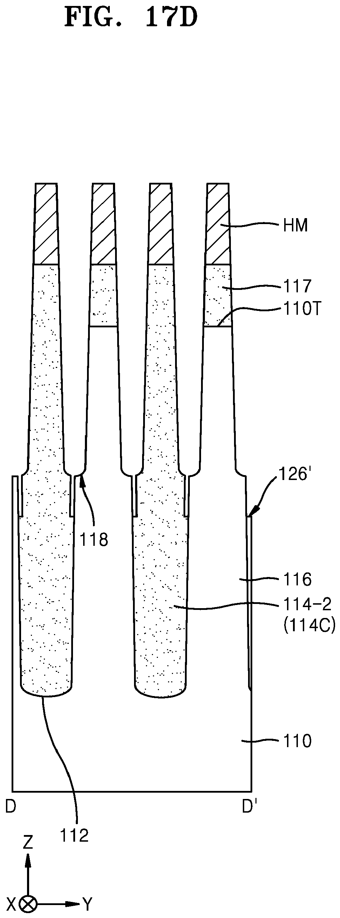

In FIGS. 17A to 17D, the protective pattern 152 (illustrated in FIG. 14C and FIG. 14D) is removed. As shown in FIGS. 17C and 17D, the protective pattern 152, which are formed on both sidewalls of the patterned buffer insulating layer 117 and the hard mask patterns HM, are removed. The protective pattern 152 may be removed using wet etching or dry etching.

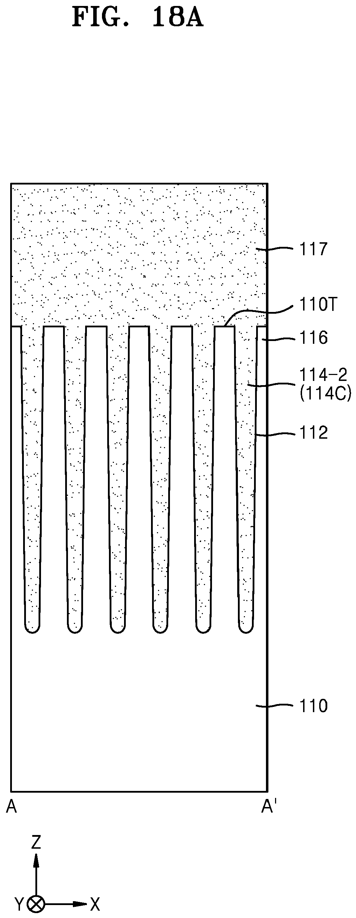

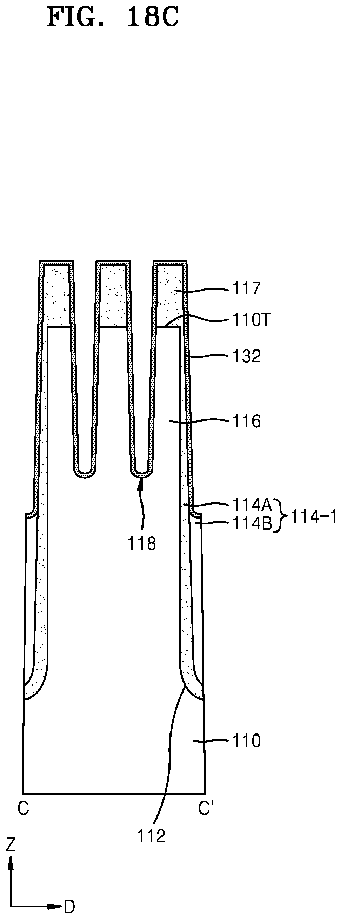

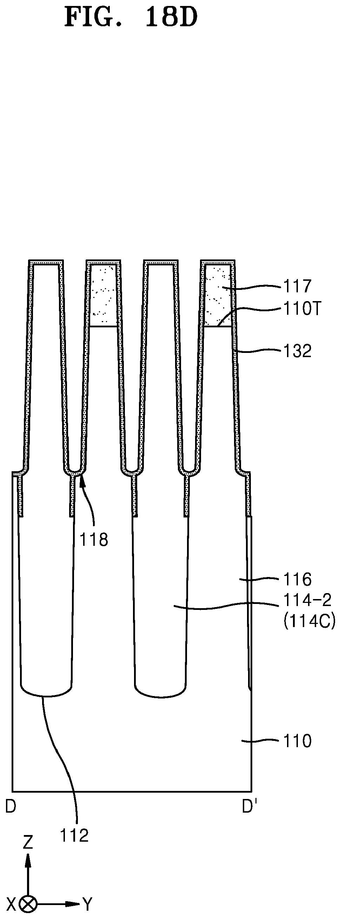

In FIGS. 18A to 18D, the hard mask patterns HM are removed. Subsequently, similarly to FIGS. 8A to 8D, the gate insulating layer 132 is formed on the patterned buffer insulating layer 117, the second active fins F2, the active regions 116, and the first field insulating layer 114-1 and the second field insulating layer 114-2.

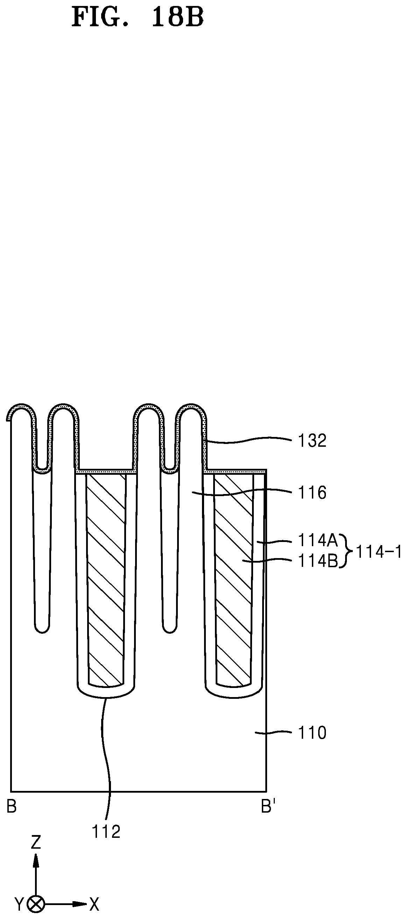

As shown in FIG. 18B, the gate insulating layer 132 is formed to cover the second active fins F2. Because a material for forming the gate insulating layer 132 is described above, a description thereof is omitted. Subsequently, an IC semiconductor device may be manufactured by performing the manufacturing process described above with reference to FIGS. 9A to 11D.

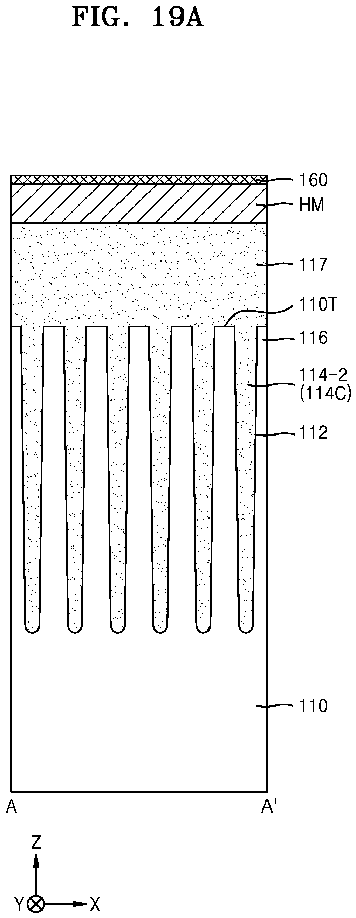

FIGS. 19A to 23D are cross-sectional views illustrating a method of manufacturing an IC semiconductor device and an IC semiconductor device manufactured by the method according to an embodiment.

FIGS. 19A to 23D may be substantially the same as FIGS. 3A to 11D, except that a protective layer 160 and a protective pattern 162 are further formed during a manufacturing process. In FIGS. 19A to 23D, the same reference numerals as those of FIGS. 3A to 11D denote the same members. In FIGS. 19A to 23D, the same descriptions as those given above with reference to FIGS. 3A to 11D are briefly given or omitted.

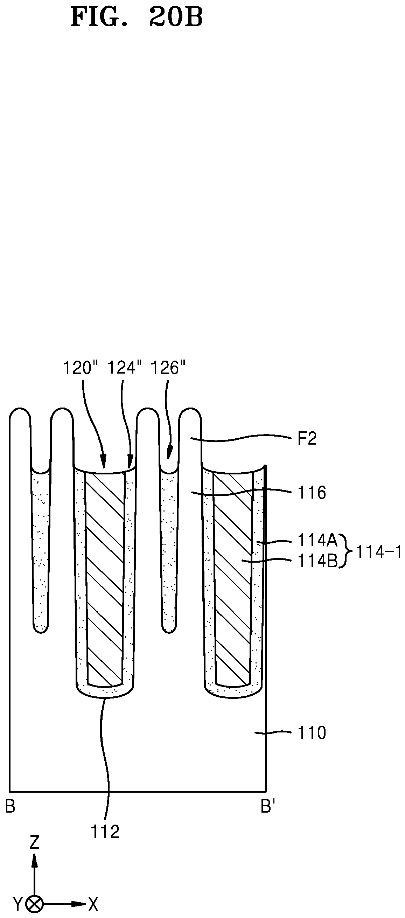

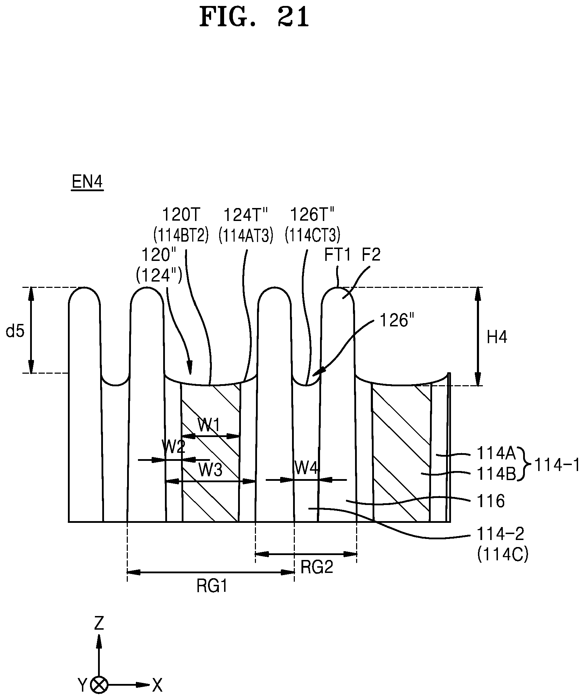

FIGS. 19A and 20A and FIGS. 22A to 23A are cross-sectional views taken along line A-A' of FIG. 2, FIGS. 19B and 20B and FIGS. 22B to 23B are cross-sectional views taken along line B-B' of FIG. 2, FIGS. 19C and 20C and FIGS. 22C to 23C are cross-sectional views taken along line C-C' of FIG. 2, and FIGS. 19D and 20D and FIGS. 22D to 23D are cross-sectional views taken along line D-D' of FIG. 2. A cross-sectional view EN4 of FIG. 21 is a partially enlarged cross-sectional view of FIG. 20B.

In FIGS. 19A to 19D, the processes of FIGS. 3A to 3D, 4A to 4D, and 5A to 5D described above are performed. Subsequently, the protective layer 160 is formed on the hard mask patterns HM, the patterned buffer insulating layer 117, the active regions 116, the first field insulating layer 114-1 and the second field insulating layer 114-2, and the first field recess hole 120 and the second field recess hole 122. The protective layer 160 may include a silicon nitride layer.

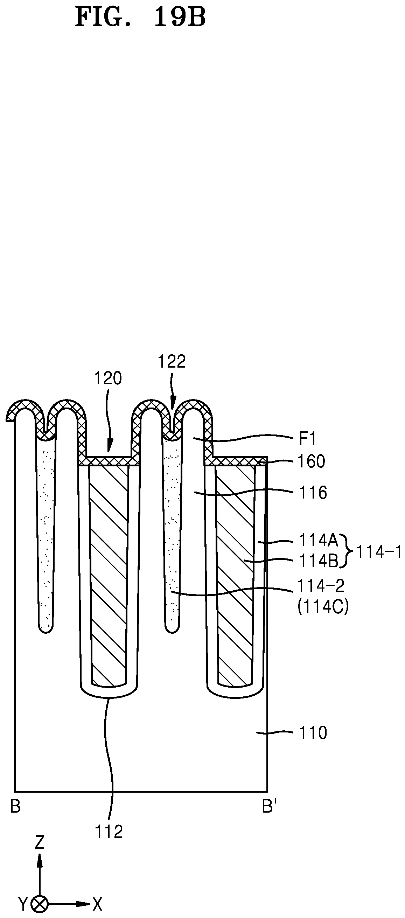

In FIG. 19A, the protective layer 160 may be formed on the hard mask patterns HM. In FIG. 19B, the protective layer 160 is formed on the first field recess hole 120 and the second field recess hole 122, the active regions 116, and the first field insulating layer 114-1 and the second field insulating layer 114-2.

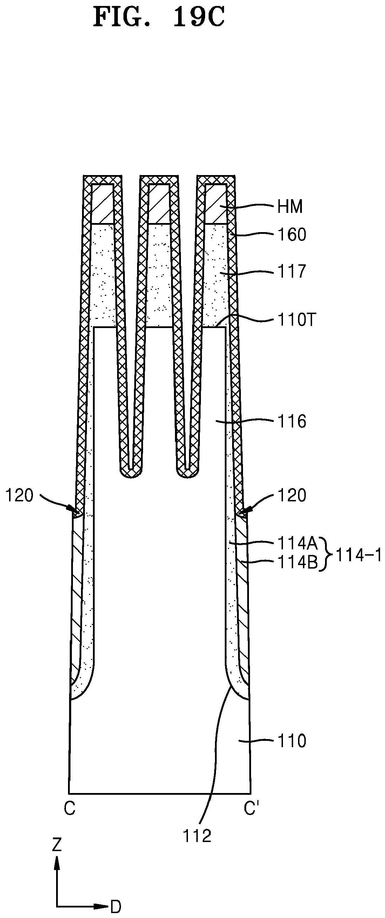

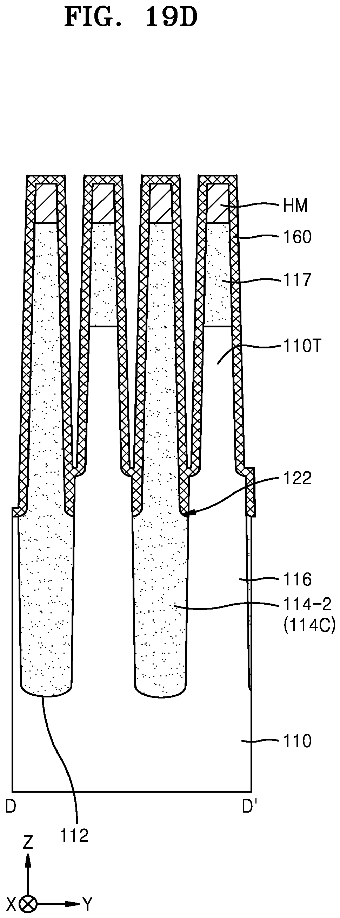

In FIGS. 19C and 19D, the protective layer 160 is formed on the first field recess hole 120 and the second field recess hole 122, the patterned buffer insulating layer 117, the active regions 116, and the first field insulating layer 114-1 and the second field insulating layer 114-2.

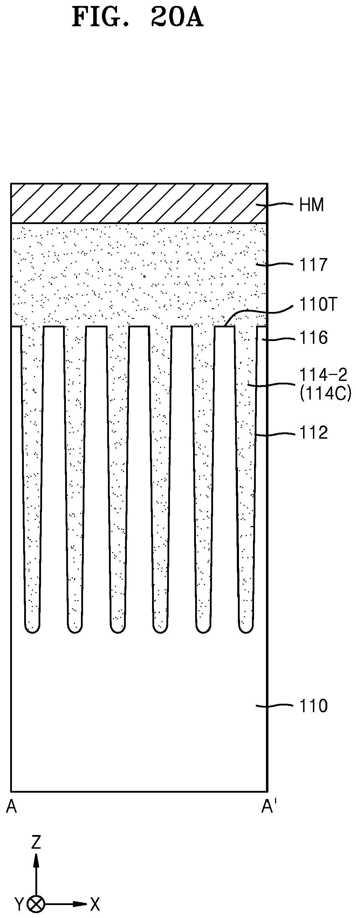

In FIGS. 20A to 20D, similarly to FIGS. 6A to 6D, the primarily etched first field insulating layer 114-1 and the second field insulating layer 114-2 are secondarily etched using the hard mask patterns HM and the protective layer 160 as an etch mask to form a deformed first field recess hole 120", a deformed third field recess holes 124", and a deformed fourth field recess hole 126". A lower portion of the protective layer 160 is etched using the hard mask patterns HM as an etch mask to form a protective pattern 162, and upper portions of the first field insulating layer 114-1 and the second field insulating layer 114-2 are secondarily etched to form the deformed first field recess hole 120" and the deformed third field recess holes 124" and the deformed fourth field recess hole 126".

In some embodiments, the secondary etching may be performed as a wet etching method or a dry etching method. In some embodiments, the secondary etching may be performed as a non-plasma-based dry etching method. In some embodiments, the secondary etching may be performed as a COR method. The COR method may be a silicon oxide etching method using HF and NH₃ gas.

The deformed first field recess hole 120" and the deformed third field recess holes 124" and the deformed fourth field recess hole 126" may be formed by etching upper portions of the primarily etched first field insulating layer 114-1 and the second field insulating layer 114-2. Lower surfaces of the deformed first field recess hole 120" and the deformed third field recess holes 124" and the deformed fourth field recess hole 126" may be located at a level lower than that of the surface of the active regions 116.

As shown in FIG. 20B, due to the formation of the deformed first field recess hole 120", the deformed third field recess hole 124" and the deformed fourth field recess hole 126", the active regions 116 may be exposed more than the surfaces of the first field insulating layer 114-1 and the second field insulating layer 114-2 to form the second active fins F2. As shown in FIG. 19D, the deformed fourth field recess hole 126" may not be formed in the second field insulating layer 114-2 due to the protective layer (160 of FIG. 19D).

In some embodiments, as shown in FIG. 20B, the deformed first field recess hole 120" and the deformed third field recess hole 124" may have the same surface. The surfaces of the deformed first field recess hole 120" and the deformed third field recess hole 124" may have a concave shape, e.g., a concave surface.

As shown in FIG. 20B, the fourth field recess hole 126" may be formed by recess-etching the primarily etched second field insulating layer 114-2, e.g., an upper portion of the third subfield insulating layer 114C. A lower surface of the fourth field recess hole 126" may be located at a level lower than that of the surface of the active regions 116. In some embodiments, as shown in FIG. 20B, the surface of the fourth field recess hole 126" may have a concave shape, e.g., a concave surface. Surfaces of the deformed first field recess hole 120", the deformed third field recess hole 124", and the deformed fourth field recess hole 126" may be located at the same level.

In addition, due to the formation of the deformed first field recess hole 120", the deformed third field recess hole 124", and the deformed fourth field recess hole 126", the active regions 116 may protrude from the surfaces of the field insulating layers 114-1 and 114-2 to form the second active fins F2.

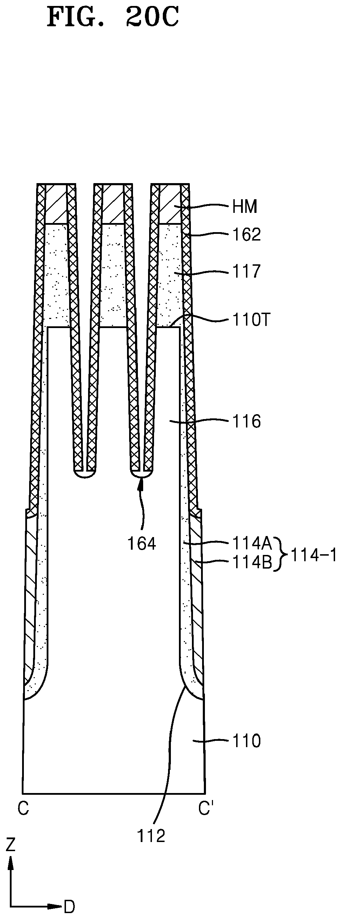

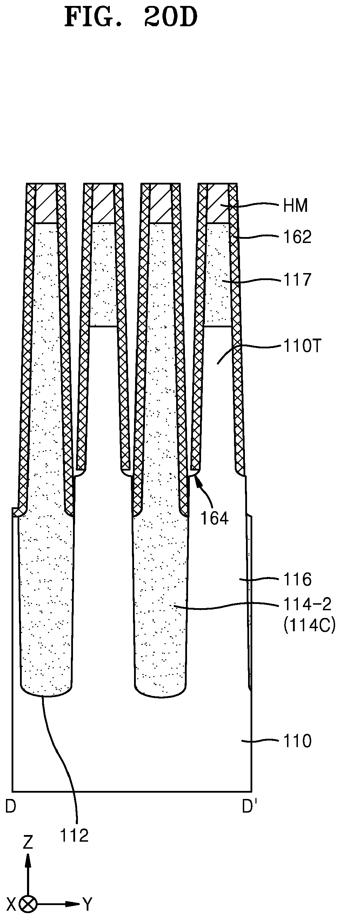

As shown in FIGS. 20C and 20D, etching loss on both sides of upper portions of the patterned buffer insulating layer 117 and the active regions 116 may be prevented when a lower portion 164 of the protective layer 160 is etched using the hard mask patterns HM as an etch mask. Accordingly, a subsequent process, e.g., a bit line forming process or a capacitor electrode forming process, may be easily performed.

Here, a relationship of the first field insulating layer 114-1 and the second field insulating layer 114-2, the deformed first field recess hole 120", the deformed third field recess hole 124", the deformed fourth field recess hole 126", the active regions 116, and the second active fins F2 is described in more detail with reference to FIGS. 20B and 21. The enlarged cross-sectional view EN4 of FIG. 21 may be a cross-sectional view of a partial region of FIG. 20B. In the enlarged cross-sectional view EN4 of FIG. 21, the same or similar descriptions as those given above with reference to FIG. 7 are briefly given or omitted.

As shown in FIGS. 20B and 21, the surface 120T of the deformed first field recess hole 120" and the surface 124T" of the deformed third field recess hole 124" have a concave shape, e.g., a concave surface. The surface 126T" of the deformed fourth field recess hole 126" may have a concave shape, e.g., a concave surface.

In other words, the surface 114BT2 of the second subfield insulating layer 114B and the surface 114AT3 of the first subfield insulating layer 114A may have a concave shape, e.g., a concave surface. The surface 114CT3 of the third subfield insulating layer 114C may have a concave shape, e.g., a concave surface. The surfaces of the deformed first field recess hole 120", the deformed third field recess hole 124", and the deformed fourth field recess hole 126" may have the same level.

The deformed first field recess hole 120", the deformed third field recess hole 124", and the deformed fourth field recess hole 126" may have a fifth depth d5 from the uppermost end FT1 of the second active fins F2 to the surface 114BT2 of the second subfield insulating layer 114B and the surface 114CT3 of the third subfield insulating layer 114C-2. In some embodiments, the fifth depth d5 may be several nm to several tens of nm.

The active regions 116 may protrude from the surfaces of the first field insulating layer 114-1 and the second field insulating layer 114-2 to form the second active fins F2. The second active fins F2 may have a fourth height H4 from the surface 114BT2 of the second subfield insulating layer 114B and the surface 114CT3 of the third subfield insulating layer 114C-2 to the uppermost end FT1. The fifth depth d5 and the fourth height H4 may have the same value.

In the IC semiconductor device as described above, the fourth height H4 of the second active fins F2 may be adjusted by adjusting the fifth depth d5 of the deformed first field recess hole 120", the deformed third field recess hole 124", and the deformed fourth field recess hole 126".

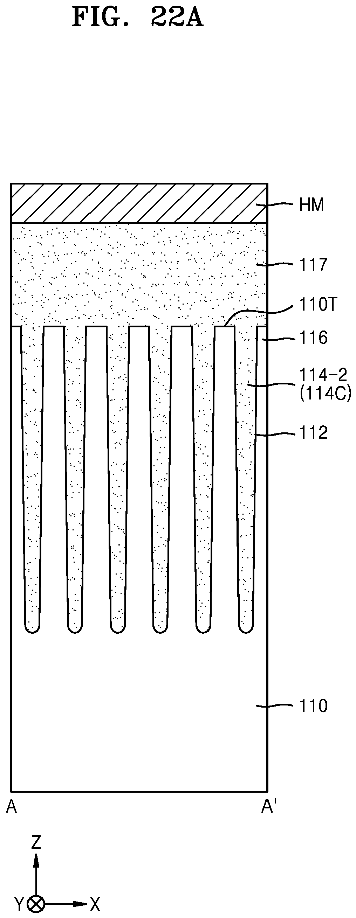

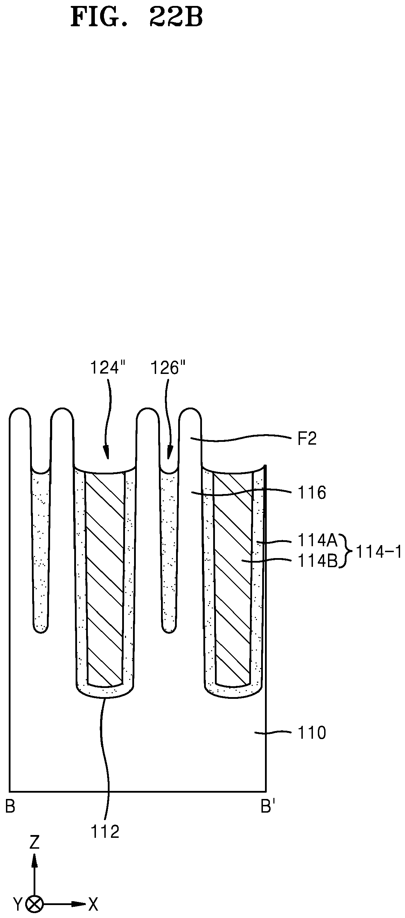

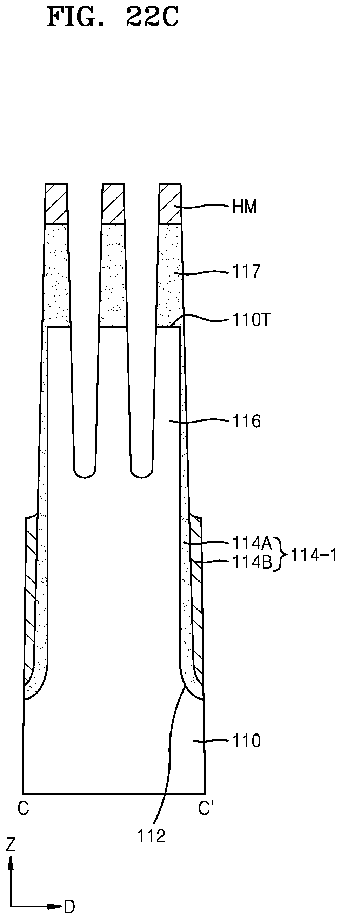

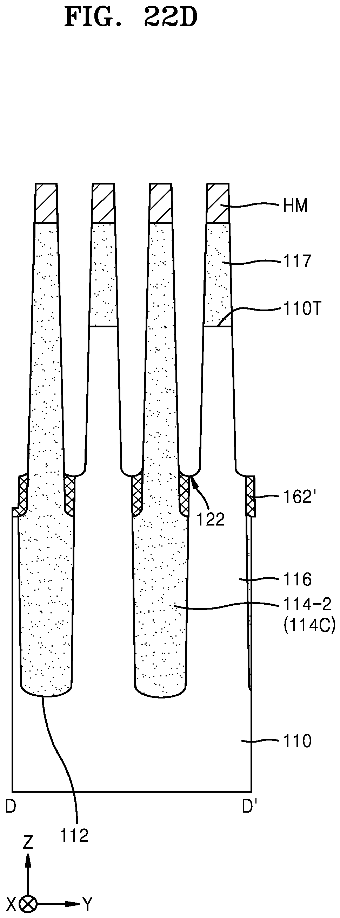

In FIGS. 22A to 22D, the protective pattern 162 is partially removed. As shown in FIGS. 22C and 22D, the protective pattern 162 formed on upper portions of both sidewalls of the patterned buffer insulating layer 117 and the hard mask patterns HM is removed. The protective pattern 162 may be partially removed using wet etching or dry etching.

As shown in FIG. 22D, a protective pattern 162' remains in the second field recess hole 122 formed at an upper portion of the second field insulating layer 114-2, e.g., the third subfield insulating layer 114C. In other words, the protective pattern 162' may remain on upper side surfaces of the active regions 116 surrounded by the second field insulating layer 114-2.

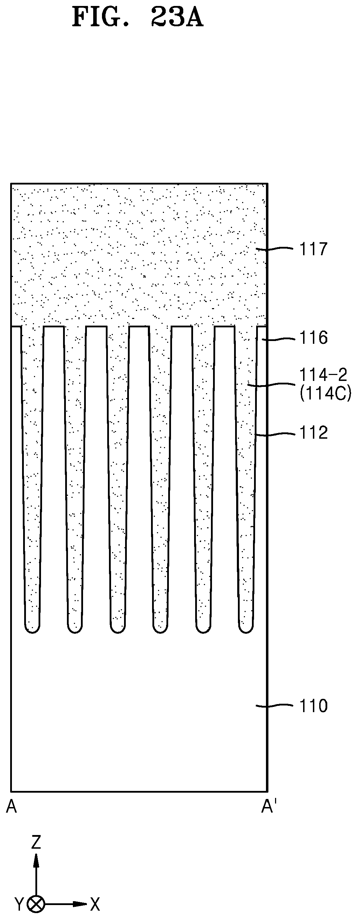

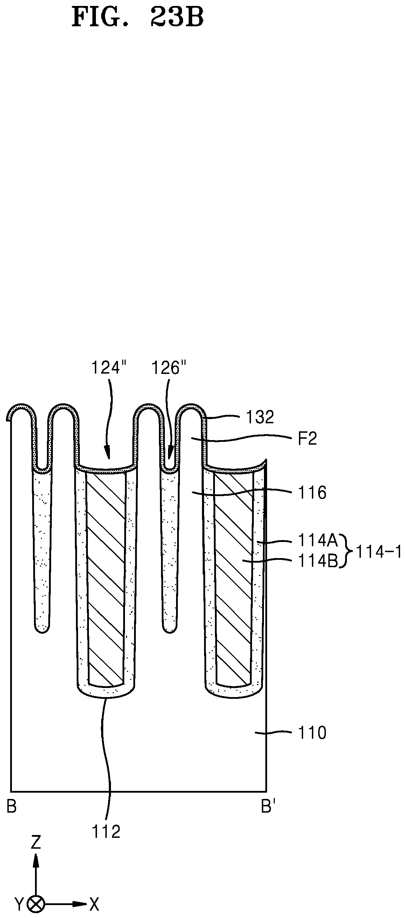

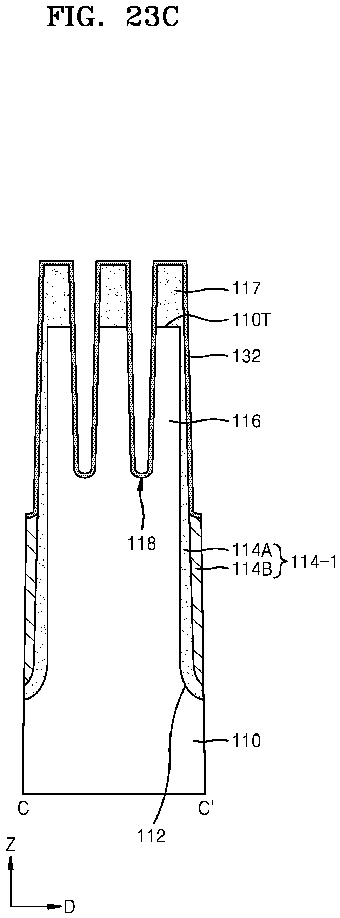

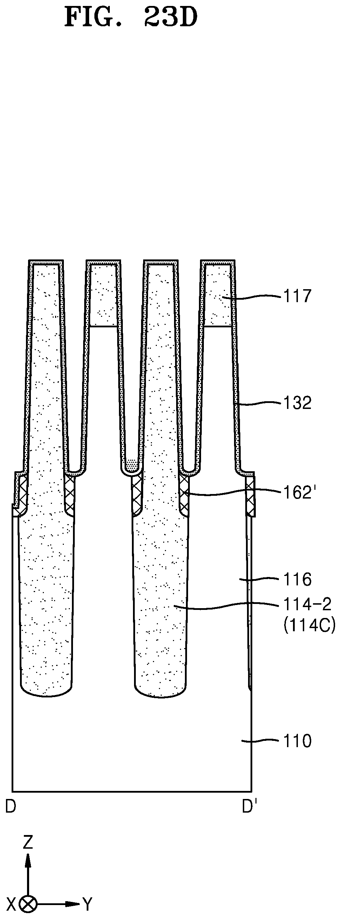

In FIGS. 23A to 23D, the hard mask patterns HM are removed. Subsequently, similarly to FIGS. 8A to 8D, the gate insulating layer 132 is formed on the patterned buffer insulating layer 117, the second active fins F2, the active regions 116, and the first field insulating layer 114-1 and the second field insulating layer 114-2. As shown in FIG. 23B, the gate insulating layer 132 is formed to cover the second active fins F2. Because a material for forming the gate insulating layer 132 is described above, a description thereof is omitted. Subsequently, an IC semiconductor device may be manufactured by performing the manufacturing process described above with reference to FIGS. 9A to 11D.

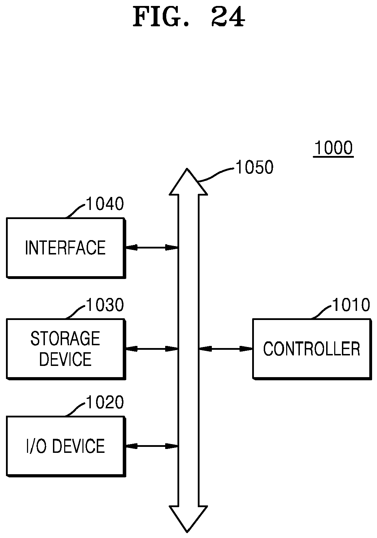

FIG. 24 is a system 1000 including an IC semiconductor device according to an embodiment of the present disclosure. According to an embodiment of the present disclosure, the system 1000 may include a controller 1010, an Input/Output (I/O) device 1020, a storage device 1030, and an interface 1040. The system 1000 may be a mobile system or a system for transmitting or receiving information. In some embodiments, the mobile system may include Personal Digital Assistants (PDAs), portable computers, web tablets, wireless phones, mobile phones, digital music players, or memory cards.

The controller 1010 is configured to control an executable program in the system 1000, and may include microprocessors, digital signal processors, microcontrollers, or similar devices. The I/O device 1020 may be used to input or output data of the system 1000. The system 1000 may be connected to an external device, e.g., a personal computer or a network, using the I/O device 1020, and may exchange data with the external device. The I/O device 1020 may include, e.g., keypads, keyboards, or displays.

The storage device 1030 may store codes and/or data for the operation of the controller 1010 or data processed by the controller 1010. The storage device 1030 may include the IC semiconductor device 100 according to an embodiment of the present disclosure. The interface 1040 may be a data transmission path between the system 1000 and another external device. The controller 1010, the I/O device 1020, the storage device 1030, and the interface 1040 may communicate with each other via a bus 1050.

According to an embodiment of the present disclosure, the system 1000 may be used in, e.g., mobile phones, MP3 players, navigation systems, Portable Multimedia Players (PMPs), Solid State Disks (SSDs), or household appliances.

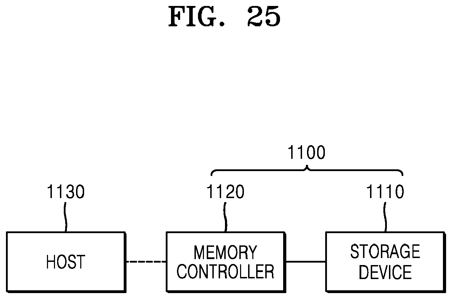

FIG. 25 is a memory card 1100 including an IC semiconductor device according to an embodiment of the present disclosure. The memory card 1100 may include a storage device 1110 and a memory controller 1120. The storage device 1110 may store data. In some embodiments, the storage device 1110 may have a non-volatile characteristic capable of maintaining stored data even when power supply thereto is interrupted. The storage device 1110 may include the IC semiconductor device 100 manufactured by the method described above.

The memory controller 1120 may read data stored in the storage device 1110 or store data of the storage device 1110 in response to a read/write request from a host 1130. The memory controller 1120 may include the IC semiconductor device 100 manufactured by the method illustrated above. According to an embodiment of the present disclosure, The IC semiconductor device may increase the height of the active fins by recess-etching the field insulating layers between the active fins. Accordingly, according to an embodiment of the present disclosure, the IC semiconductor device may have improved electrical characteristics, e.g., an improved short channel effect or current driving capability.

While the present disclosure has been particularly shown and described with reference to embodiments thereof, it will be understood that various changes in form and details may be made therein without departing from the scope of the following claims and their equivalents.

## Claims

1. An Integrated Circuit, IC, semiconductor device comprising:
field insulating layers buried in field trenches disposed apart from each other inside a substrate;
active regions defined by the field insulating layers; and
active fins disposed on the active regions and protruding from surfaces of the field insulating layers,
wherein the field insulating layers comprise a first subfield insulating layer and a second subfield insulating layer, and
wherein a surface of the first subfield insulating layer is disposed at a level lower than a level of a surface of the second subfield insulating layer.

2. The IC semiconductor device of claim 1, wherein the first subfield insulating layer comprises a material having a higher etch selectivity with respect to a hard mask pattern than an etch selectivity of the second subfield insulating layer.

3. The IC semiconductor device of claim 1 or 2, wherein:
the surface of the first subfield insulating layer has a concave shape, and
the surface of the second subfield insulating layer has a flat shape.

4. The IC semiconductor device of any one of claims 1 to 3, wherein the active regions have a same body as the active fins.

5. The IC semiconductor device of any one of claims 1 to 4, wherein a gate insulating layer and a gate electrode are sequentially formed on the active fins and the field insulating layers.

6. The IC semiconductor device of claim 5, wherein:
surfaces of the active fins and the field insulating layers are disposed at a level lower than a surface of the substrate, and
the active regions, the active fins, the gate insulating layer, and the gate electrode constitute a Buried Channel Array Transistor, BCAT.

7. The IC semiconductor device of any one of claims 1 to 6, wherein:
the field insulating layers comprise a first field insulating layer having a first width,
a second field insulating layer having a second width that is less than the first width,
and
the first field insulating layer comprises the first subfield insulating layer and the second subfield insulating layer.

8. The IC semiconductor device of claim 7, wherein the first field insulating layer is formed in a region having a larger distance between outermost portions of the active fins than the second field insulating layer on the substrate.

9. The IC semiconductor device of claim 7 or 8, wherein:
the surface of the first subfield insulating layer has a concave shape,
the surface of the second subfield insulating layer has a flat shape, and
a surface of the second field insulating layer has a concave shape.

10. The IC semiconductor device of any one of claims 7 to 9, wherein the second field insulating layer comprises a single third subfield insulating layer.

11. The IC semiconductor device of claim 10, wherein a surface of the third subfield insulating layer is disposed at a level higher than a surface of the first subfield insulating layer.

12. The IC semiconductor device of claim 10 or 11, wherein a surface of the third subfield insulating layer has a concave shape.

13. An integrated circuit, IC, semiconductor device comprising:
field insulating layers buried in field trenches disposed apart from each other inside a substrate;
active regions defined by the field insulating layers; and
active fins disposed on the active regions and protruding from surfaces of the field insulating layers,
wherein:
the field insulating layers comprise a first field insulating layer having a first width and a second field insulating layer having a second width that is less than the first width,
the first field insulating layer comprises a first subfield insulating layer and a second subfield insulating layer, and
a surface of the first subfield insulating layer and a surface of the second subfield insulating layer have concave shapes.

14. The IC semiconductor device of any one of claims 7 to 13, wherein protective patterns are further formed on both sidewalls of the second field insulating layer that is in contact with the active regions.

15. The IC semiconductor device of any one of claims 1 to 14, wherein a surface of the first field insulating layer has a same height as a surface of the second field insulating layer.
